(19) Europäisches Patentamt / European Patent Office / Office européen des brevets

(11) **EP 3 952 122 A1**

(12) **EUROPEAN PATENT APPLICATION**
published in accordance with Art. 153(4) EPC

(43) Date of publication:
**09.02.2022 Bulletin 2022/06**

(21) Application number: **19925318.8**

(22) Date of filing: **17.04.2019**

(51) International Patent Classification (IPC):
**H04B 7/0413** (2017.01)     **G01R 29/10** (2006.01)
**H04B 7/06** (2006.01)

(52) Cooperative Patent Classification (CPC):
**G01R 29/10; H04B 7/0413; H04B 7/06;** Y02D 30/70

(86) International application number:
**PCT/JP2019/016506**

(87) International publication number:
**WO 2020/213093 (22.10.2020 Gazette 2020/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Sony Group Corporation**
**Tokyo 108-0075 (JP)**

(72) Inventor: **NAKAYAMA, Takashi**
**Tokyo 140-0002 (JP)**

(74) Representative: **D Young & Co LLP**
**120 Holborn**
**London EC1N 2DY (GB)**

(54) **INFORMATION PROCESSING DEVICE, INFORMATION PROCESSING SYSTEM, TERMINAL DEVICE, AND INFORMATION PROCESSING METHOD**

(57)   To reduce an influence of errors caused by a hardware configuration of an antenna device in controlling directivity of a radio signal in a more preferable manner.

An information processing device includes a generation unit that generates control information for controlling directivity of a radio signal transmitted from an antenna device including a plurality of antenna elements, in which the generation unit acquires first information according to a measurement result of a phase of a radio signal transmitted from a first antenna element among the plurality of antenna elements, and second information according to a measurement result of a relative deviation between the phase of the radio signal transmitted from the first antenna element and a phase of a radio signal transmitted from a second antenna element different from the first antenna element, and generates the control information based on the first information and the second information.

FIG.10

EP 3 952 122 A1

## Description

Field

The present disclosure relates to an information processing device, an information processing system, a terminal device, and an information processing method.

Background

In mobile communication systems based on a communication standard called LTE/LTE-advanced (LTE-A), radio signals with a frequency called ultra-high frequency around 700 MHz to 3.5 GHz are mainly used for communication.

In addition, in communication using ultra-high frequency waves such as the above communication standard, by adopting so-called multiple-input and multiple-output (MIMO) technology, it is possible to further improve communication performance by using reflected waves for signal transmission and reception in addition to direct waves even in a fading environment. Since a plurality of antennas are used in the MIMO, various methods for arranging a plurality of antennas in a more preferable manner for a terminal device for mobile communication such as a smartphone have been studied.

In addition, in recent years, various studies have been conducted on the 5th generation (5G) mobile communication system following LTE/LTE-A. For example, in the mobile communication system, the use of communication using a radio signal (hereinafter, also simply referred to as "millimeter wave") having a frequency called a millimeter wave such as 28 GHz or 39 GHz is being studied. In general, millimeter waves have a relatively large spatial attenuation, and when millimeter waves are used for communication, antennas with a high gain tend to be required. In order to realize such a requirement, it is considered to use the directional beam for communication between a base station and a terminal device by forming a directional beam by technology called beamforming. For example, Non Patent Literature 1 discloses, in particular, contents of a study on the use of beamforming technology as a study on communication using millimeter waves in a 5G mobile communication system.

Citation List

Non Patent Literature

Non Patent Literature 1: Satoshi Suyama et al., "5G Multi-Antenna Technology", NTT DOCOMO Technical Journal, Vol.23, No.4, 2016, pp. 30 to 39

Summary

Technical Problem

The accuracy of controlling the directivity of the radio signal based on the beamforming technology may be due to the accuracy of controlling phases of radio signals transmitted from each of the plurality of antenna elements included in the antenna device. On the other hand, due to device-specific characteristics such as a difference in materials constituting the antenna device and a difference in wiring length, the phases of the radio signals transmitted from each of the plurality of antenna elements may shift. In particular, when a radio signal having a higher frequency such as the 5G is used, the influence of errors caused by the above-described device-specific characteristics may become larger.

Therefore, the present disclosure proposes a technology capable of reducing the influence of errors caused by the hardware configuration of the antenna device in controlling the directivity of a radio signal in a more preferable manner.

Solution to Problem

According to the present disclosure, an information processing device is provided that includes: a generation unit that generates control information for controlling directivity of a radio signal transmitted from an antenna device including a plurality of antenna elements, wherein the generation unit acquires first information according to a measurement result of a phase of a radio signal transmitted from a first antenna element among the plurality of antenna elements, and second information according to a measurement result of a relative deviation between the phase of the radio signal transmitted from the first antenna element and a phase of a radio signal transmitted from a second antenna element different from the first antenna element, and generates the control information based on the first information and the second information.

Moreover, according to the present disclosure, an information processing system is provided that includes: a terminal device including an antenna device that includes a plurality of antenna elements; and an information processing device in which the antenna device generates control information for controlling directivity of a radio signal, wherein the information processing device acquires first information according to a measurement result of a phase of a radio signal transmitted from a first antenna element among the plurality of antenna elements, and second information according to a measurement result of a relative deviation between the phase of the radio signal transmitted from the first antenna element and a phase of a radio signal transmitted from a second antenna element different from the first antenna element, and generates the control information based on the first information and the second information.

Moreover, according to the present disclosure, a terminal device is provided that includes: an antenna device including a plurality of antenna elements, and a control unit that controls directivity of a radio signal transmitted from the antenna device based on control information generated in advance, wherein the control information is generated based on first information according to a measurement result of a phase of a radio signal transmitted from a first antenna element among the plurality of antenna elements, and second information according to a measurement result of a relative deviation between the phase of the radio signal transmitted from the first antenna element and a phase of a radio signal transmitted from a second antenna element different from the first antenna element.

Moreover, according to the present disclosure, an information processing method, by a computer, is provided that includes: acquiring first information according to a measurement result of a phase of a radio signal transmitted from a first antenna element among a plurality of antenna elements included in an antenna device, and second information according to a measurement result of a relative deviation between the phase of the radio signal transmitted from the first antenna element and a phase of a radio signal transmitted from a second antenna element different from the first antenna element; and generating control information for controlling directivity of a radio signal transmitted from the antenna device based on the first information and the second information.

Brief Description of Drawings

FIG. 1 is an explanatory diagram for describing an example of a schematic configuration of a system according to an embodiment of the present disclosure.

FIG. 2 is a block diagram illustrating an example of a configuration of a base station according to the present embodiment.

FIG. 3 is a block diagram illustrating an example of a configuration of a terminal device according to the present embodiment.

FIG. 4 is a block diagram illustrating an example of a configuration of an antenna device according to the present embodiment.

FIG. 5 is a diagram illustrating an example of a system configuration of a mobile communication system assumed in NSA.

FIG. 6 is an explanatory diagram for describing an overview of an example of a cell arrangement design in 5G.

FIG. 7 is an explanatory diagram for describing an overview of a procedure of beam management.

FIG. 8 is an explanatory diagram for describing an example of a measurement system to which an IFF method is applied.

FIG. 9 is an explanatory diagram for describing an example of an EIPR measurement system using a CATR measurement system.

FIG. 10 is an explanatory diagram for describing an example of the EIPR measurement system using the CATR measurement system.

FIG. 11 is an explanatory view for describing an example of a configuration of an information processing system according to the present embodiment.

FIG. 12 is an explanatory view for describing an example of a configuration of an antenna device included in a terminal device according to the present embodiment.

FIG. 13 is a diagram illustrating an example of measurement results of a phase and power of the antenna device related to the generation of the LUT according to the present embodiment.

FIG. 14 is an explanatory view for describing a method of measuring a phase of a radio signal of the information processing system according to the present embodiment.

FIG. 15 is an explanatory view for describing a method of measuring amplitude of a radio signal of the information processing system according to the present embodiment.

FIG. 16 is a functional block diagram illustrating a configuration example of a hardware configuration of an information processing device constituting the system according to the present embodiment.

FIG. 17 is an explanatory diagram for describing an application example of a communication device according to the present embodiment.
FIG. 18 is an explanatory diagram for describing an application example of the communication device according to the present embodiment.

Description of Embodiments

Hereinafter, preferred embodiments of the present disclosure will be described in detail with reference to the accompanying drawings. Note that in the present specification and drawings, components having substantially the same functional configuration will be denoted by the same reference numerals, and a redundant description thereof will be omitted.
Note that the description will be made in the following order.

1. Configuration example
1.1. Configuration example of system
1.2. Configuration example of base station
1.3. Configuration example of terminal device
1.4. Configuration example of antenna device
2. Overview of communication assuming use of millimeter wave
3. Examination of application of beamforming technology
4. Example of measurement system related to generation of LUT
5. Technical features
6. Hardware Configuration
7. Application example
7.1. Application example 1: Application example to other communication devices
7.2. Application example 2: Application example to communication based on other communication standards
8. Conclusion

<<1. Configuration Example>>

<1.1. Configuration example of system>

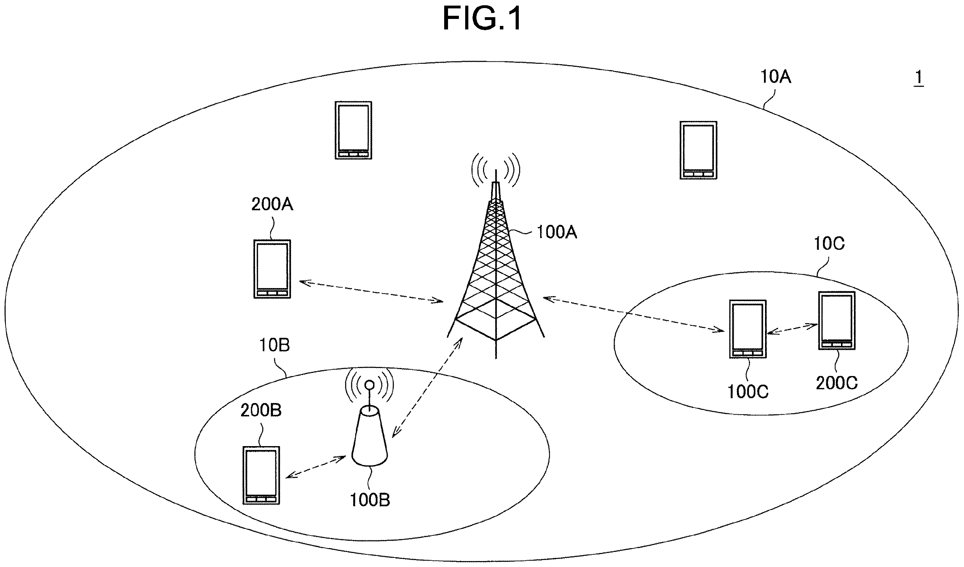

First, an example of a schematic configuration of a system 1 according to an embodiment of the present disclosure will be described with reference to FIG. 1. FIG. 1 is an explanatory diagram for describing an example of a schematic configuration of a system 1 according to an embodiment of the present disclosure. As illustrated in FIG. 1, the system 1 includes a wireless communication device 100 and a terminal device 200. Here, the terminal device 200 is also called a user. The user may also be called UE. A wireless communication device 100C is also called UE-Relay. Here, the UE may be UE defined in LTE or LTE-A, and the UE-Relay may be a Prose UE to Network Relay discussed in 3GPP, and more generally, may mean communication equipment.

(1) Wireless communication device 100

The wireless communication device 100 is a device that provides a wireless communication service to a subordinate device. For example, a wireless communication device 100A is a base station of a cellular system (or a mobile communication system). The base station 100A performs wireless communication with a device (for example, terminal device 200A) located inside a cell 10A of the base station 100A. For example, the base station 100A transmits a downlink signal to the terminal device 200A and receives an uplink signal from the terminal device 200A.
The base station 100A is logically connected to other base stations by, for example, an X2 interface, and can transmit and receive control information and the like. In addition, the base station 100A is logically connected to a so-called core network (not illustrated) by, for example, an S1 interface, and can transmit and receive the control information and the like. Note that the communication between these devices can be physically relayed by various devices.
Here, the wireless communication device 100A illustrated in FIG. 1 is a macrocell base station, and the cell 10A is a macrocell. On the other hand, wireless communication devices 100B and 100C are master devices that operate small cells 10B and 10C, respectively. As an example, the master device 100B is a small cell base station that is fixedly installed. The small cell base station 100B establishes a wireless backhaul link with the macro cell base station 100A, and establishes an access link with one or more terminal devices (for example, terminal device 200B), respectively, in the small cell 10B. Note that the wireless communication device 100B may be a relay node defined by 3GPP. The master device 100C is a dynamic access point (AP). The dynamic AP 100C is a mobile device that dynamically operates the small cell 10C. The dynamic AP 100C establishes a wireless backhaul link with the macro cell base station 100A, and establishes an access link with one or more terminal devices (for example, terminal device 200C), respectively, in the small cell 10C. The dynamic AP 100C may be, for example, a terminal device equipped with hardware or software operable as a base station or a wireless access point. In this case, the small cell 10C in this case is a dynamically formed localized network (localized network/virtual cell).

The cell 10A may be operated according to any wireless communication scheme such as LTE, LTE-Advanced (LTE-A), LTE-Advanced PRO, GSM (registered trademark), UMTS, W-CDMA, CDMA2000, WiMAX, WiMAX2, or IEEE802.16.

Note that a small cell is a concept that can include various types of cells (for example, femtocells, nanocells, picocells, microcells, and the like) that are arranged to overlap or do not overlap with a macrocell and are smaller than the macrocell. In one example, the small cell is operated by a dedicated base station. In another example, the small cell is operated by allowing a terminal serving as a master device to temporarily operate as a small cell base station. A so-called relay node can also be considered as a form of the small cell base station. A wireless communication device functioning as a master station of the relay node is also called a donor base station. The donor base station may mean DeNB in LTE, or more generally the master station of the relay node.

(2) Terminal device 200

The terminal device 200 can communicate in a cellular system (or a mobile communication system). The terminal device 200 performs wireless communication with the wireless communication device (for example, base station 100A, and master device 100B or 100C) of the cellular system. For example, the terminal device 200A receives a downlink signal to the base station 100A and transmits an uplink signal to the base station 100A.

In addition, as the terminal device 200, a so-called UE only is not applied, but a so-called low cost UE such as an MTC terminal, an Enhanced MTC (eMTC) terminal, and an NB-IoT terminal may be applied.

(3) Supplement

Hereinabove, the schematic configuration of the system 1 has been described above, but the present technology is not limited to the example illustrated in FIG. 1. For example, as a configuration of the system 1, a configuration not including the master device, small cell enhancement (SCE), a heterogeneous network (HetNet), an MTC network, or the like can be adopted. In addition, as another example of the configuration of the system 1, the master device may be connected to the small cell, and the cell may be constructed under the small cell.

<1.2. Configuration example of base station>

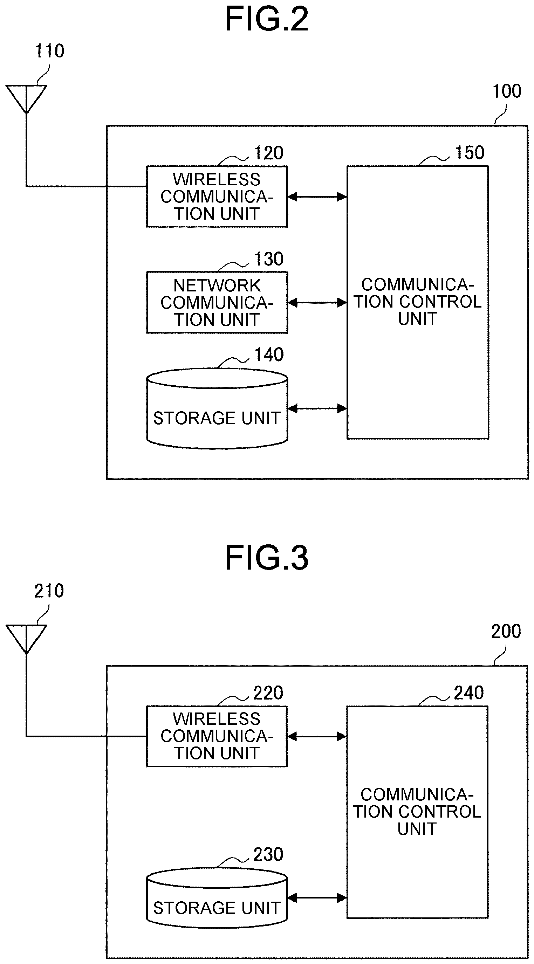

Next, the configuration of the base station 100 according to an embodiment of the present disclosure will be described with reference to FIG. 2. FIG. 2 is a block diagram illustrating an example of the configuration of the base station 100 according to an embodiment of the present disclosure. Referring to FIG. 2, the base station 100 includes an antenna unit 110, a wireless communication unit 120, a network communication unit 130, a storage unit 140, and a communication control unit 150.

(1) Antenna unit 110

The antenna unit 110 radiates a signal output from the wireless communication unit 120 to space as a radio wave. Further, the antenna unit 110 converts the radio wave in the space into a signal and outputs the signal to the wireless communication unit 120.

(2) Wireless communication unit 120

The wireless communication unit 120 transmits and receives a signal. For example, the wireless communication unit 120 transmits a downlink signal to the terminal device and receives an uplink signal from the terminal device.

(3) Network communication unit 130

The network communication unit 130 transmits and receives information. For example, the network communication unit 130 transmits information to other nodes and receives information from other nodes. For example, the other nodes include other base stations and core network nodes.

As described above, in the system 1 according to the present embodiment, the terminal device may operate as a relay terminal and may relay communication between a remote terminal and the base station. In such a case, for example, the wireless communication device 100C corresponding to the relay terminal may not include the network communication unit 130.

(4) Storage unit 140

The storage unit 140 temporarily or permanently stores a program and various data for the operation of the base station 100.

(5) Communication control unit 150

The communication control unit 150 controls the operation of the wireless communication unit 120 to control communication with another device (for example, terminal device 200) via a wireless communication path. As a specific example, the communication control unit 150 generates a transmission signal by modulating data to be transmitted based on a predetermined modulation method, and the wireless communication unit 120 may transmit the transmission signal toward the terminal device 200 in the cell. Further, as another example, the communication control unit 150 may acquire the reception result (that is, the received signal) of the signal from the terminal device 200 from the wireless communication unit 120, and perform a predetermined modulation processing on the received signal to demodulate the data transmitted from the terminal device 200.

Further, the communication control unit 150 may control communication between other base stations 100 and each entity constituting a core network by controlling the operation of the network communication unit 130.

Note that the configuration of the base station 100 described above with reference to FIG. 2 is merely an example, and does not necessarily limit the functional configuration of the base station 100. As a specific example, a part of each configuration of the base station 100 may be provided outside the base station 100. Further, each function of the base station 100 may be realized by operating a plurality of devices in cooperation with each other.

<1.3. Configuration example of terminal device>

Next, an example of the configuration of the terminal device 200 according to an embodiment of the present disclosure will be described with reference to FIG. 3.

FIG. 3 is a block diagram illustrating an example of the configuration of the terminal device 200 according to the embodiment of the present disclosure. As illustrated in FIG. 3, the terminal device 200 includes an antenna unit 210, a wireless communication unit 220, a storage unit 230, and a communication control unit 240.

(1) Antenna unit 210

The antenna unit 210 radiates a signal output from the wireless communication unit 220 to space as a radio wave. Further, the antenna unit 210 converts the radio wave in the space into a signal and outputs the signal to the wireless communication unit 220. Note that as the antenna unit 210, a plurality of antenna elements may be provided.

(2) Wireless communication unit 220

The wireless communication unit 220 transmits and receives a signal. For example, the wireless communication unit 220 receives a downlink signal from the base station and transmits an uplink signal to the base station.

In addition, as described above, in the system 1 according to the present embodiment, the terminal device may operate as a relay terminal and may relay communication between a remote terminal and the base station. In such a case, for example, the wireless communication unit 220 in the terminal device 200C operating as a remote terminal may transmit and receive a side link signal to and from a relay terminal.

(4) Storage unit 230

The storage unit 230 temporarily or permanently stores a program and various data for the operation of the terminal device 200.

(5) Communication control unit 240

The communication control unit 240 controls the operation of the wireless communication unit 220 to control communication with another device (for example, base station 100) via a wireless communication path. As a specific example, the communication control unit 240 generates a transmission signal by modulating data to be transmitted based on a predetermined modulation method, and the wireless communication unit 220 may transmit the transmission signal toward the base station 100. Further, as another example, the communication control unit 240 may acquire the reception result (that is, the received signal) of the signal from the base station 100 from the wireless communication unit 220, and perform the predetermined demodulation processing on the received signal to demodulate the data transmitted from the base station 100.

Note that the configuration of the terminal device 200 described above with reference to FIG. 3 is merely an example, and does not necessarily limit the functional configuration of the terminal device 200. As a specific example, a part of each configuration of the terminal device 200 may be provided outside the terminal device 200. As a more specific example, at least one of the antenna unit 210, the wireless communication unit 220, and the storage unit 230 illustrated in FIG. 3 may be externally attached to the terminal device 200.

<1.4. Configuration example of antenna device>

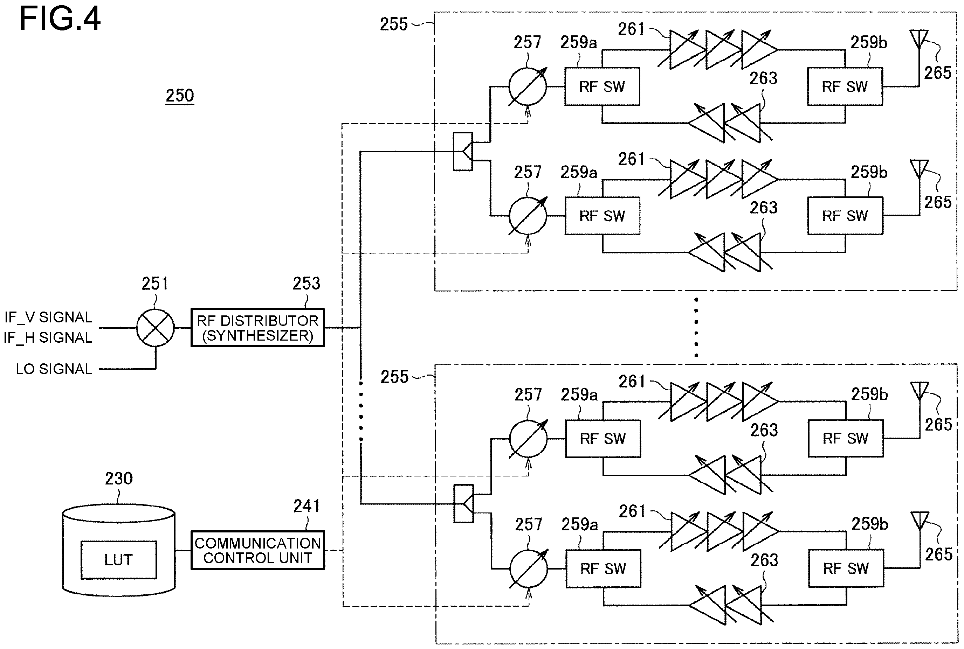

Next, an example of the antenna device included in the terminal device 200 according to an embodiment of the present disclosure will be described with reference to FIG. 4. FIG. 4 is a block diagram illustrating an example of the configuration of the antenna device 250 according to the embodiment of the present disclosure, and illustrates an example of the configuration of the antenna device configured so that the directivity of the radio signal can be controlled by the beamforming technology. Note that FIG. 4 illustrates an example of a configuration of parts corresponding to the antenna unit 210 and a part related to the control of the antenna unit 210 of the communication control unit 240 in the example illustrated in FIG. 3, as an example of a configuration of the antenna device 250.

As illustrated in FIG. 4, the antenna device 250 includes a plurality of antenna units 255, a mixer 251, an RF distributor (synthesizer) 253, a storage unit 230, and a communication control unit 241.

It is assumed that the antenna device 250 illustrated in FIG. 4 is configured to be capable of transmitting V polarization and H polarization as a radio signal. That is, in FIG. 4, an IF_V signal and an IF_H signal indicate a signal corresponding to V polarization and a signal corresponding to H polarization among analog signals according to a modulation result of data to be transmitted, respectively. Further, an LO signal schematically illustrates an output signal from a local oscillator used for converting the IF_V signal and the IF_H signal into a millimeter-wave RF signal. That is, each of the IF_V signal and the IF_H signal is converted into the millimeter-wave RF signal by being mixed with the LO signal by the mixer 251. Then, each of the IF_V signal and the IF_H signal converted into the millimeter-wave RF signal is supplied to each antenna unit 255 by the RF distributor (synthesizer) 253.

The antenna unit 255 schematically illustrates a configuration including a plurality of antenna elements included in the antenna device 250 and a group of circuits for transmitting and receiving radio signals via the antenna elements. As a specific example, when the antenna device 250 includes a plurality of patch antennas, the antenna unit 255 schematically illustrates a part corresponding to each patch antenna. Further, the antenna unit 255 includes two systems including a configuration for transmitting and receiving the I polarization and a configuration for transmitting and receiving the H polarization, among the radio signals transmitted and received. Note that each of these configurations has substantially the same configuration except that the polarization to be transmitted is different. Therefore, in the following, only the configuration related to the transmission and reception of one polarization will be described, and the detailed description of the configuration related to the transmission and reception of the other polarization will be omitted.

The configuration for transmitting each polarization includes a phaser 257, RF switches 259a and 259b, amplifiers 261 and 263, and an antenna element 265.

The antenna element 265 schematically illustrates a part of the antenna element included in the antenna unit 255 for the transmission and reception of the targeted polarization. As a specific example, when the antenna unit 255 is configured as a patch antenna, the antenna element 265 schematically illustrates a part of the flat plate-like antenna element for the transmission of the targeted polarization. That is, the antenna element 265 radiates a millimeter-wave RF signal (transmission signal) supplied from an RF switch 259b side to a space as a radio wave (radio signal). Further, the antenna element 265 converts the radio wave in the space into the millimeter-wave RF signal (received signal), and supplies the millimeter-wave RF signal to an RF switch 259 side.

The phaser 257 controls the phase of the input signal. Specifically, the millimeter-wave RF signal (transmission signal) to be transmitted is input to the phaser 257 from the RF distributor (synthesizer) 253 side, and has the phase adjusted by the phaser 257, and then input to the RF switch 259a. Further, the millimeter-wave RF signal (received signal) obtained by converting the radio wave in the space by the antenna element 265 is input from the RF switch 259a side to the phaser 257, has the phase adjusted by the phaser 257, and then input to the RF distributor (synthesizer) 253.

Each of the amplifiers 261 and 263 amplifies the input signal (millimeter-wave RF signal). Specifically, the amplifier 261 amplifies the transmission signal. In addition, the amplifier 263 also amplifies the received signal. Further, each of the amplifiers 261 and 263 may be configured to be able to control the gain related to the amplification of the signal.

The RF switches 259a and 259b switch a path through which the millimeter-wave RF signal is propagated. Specifically, when the antenna unit 255 transmits the radio signal, the RF switches 259a and 259b control the path through which the transmitted signal is propagated so that the transmitted signal output from the phaser 257 is supplied to the antenna element 265 via the amplifier 261. Further, when the antenna unit 255 receives the radio signal, the RF switches 259a and 259b control the path through which the received signal is propagated so that the received signal obtained by converting the radio waves in space by the antenna element 265 is supplied to the phaser 257 via the amplifier 263.

The communication control unit 241 controls the phase of the millimeter-wave RF signal input to the phaser 257 by controlling the operation of each phaser 257 included in each antenna unit 255. Further, the communication control unit 241 may control the gain related to the amplification of the signal by the amplifiers 261 and 263 included in each antenna unit 255. With such a configuration, for example, the communication control unit 241 can control the directivity of the beam related to the transmission of the radio signal by the antenna device 250 by individually controlling each phaser 257 included in each antenna unit 255. Further, in this case, the communication control unit 241 may individually control the operation of the amplifier 261 included in each antenna unit 255. Similarly, the communication control unit 241 can control the directivity of the beam related to the reception of the radio signal by the antenna device 250 by individually controlling each phaser 257 included in each antenna unit 255. Further, in this case, the communication control unit 241 may individually control the operation of the amplifier 263 included in each antenna unit 255.

Further, the communication control unit 241 may read and use information unique to each antenna unit 255 from a lookup table (LUT) held in the storage unit 230 when controlling the operation of at least one of the phaser 257, the amplifier 261 and the amplifier 263 included in each antenna unit 255. With such a configuration, the communication control unit 241 can reduce (and thus suppress) the influence of delays (for example, the delay caused by the difference in the wiring length of the millimeter-wave antenna element on the substrate) and the like caused by factors unique to each antenna unit 255. The details of the above LUT will be described later. Further, the LUT corresponds to an example of "control information" for controlling the directivity of the radio signal transmitted from the antenna device.

<<2. Overview of communication assuming use of millimeter wave>>

In recent years, various studies have been conducted on the 5th generation (5G) mobile communication system following LTE/LTE-A, and as a next-generation wireless access method, the introduction of radio access technology (RAT) different from LTE, which is also called new radio (NR) is also being considered.

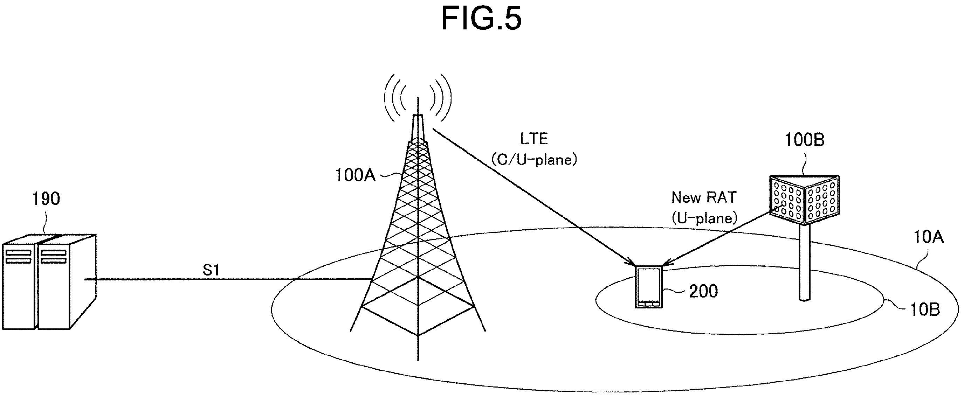

In addition, when introducing the NR, a standard called non-standalone (NSA), which is supposed to be used in combination with the existing LTE network, is being studied. For example, FIG. 5 is a diagram illustrating an example of a system configuration of the mobile communication system assumed in the NSA. As illustrated in FIG. 5, in the NSA, C-plain (control information) is transmitted and received between the macro cell base station 100A and the terminal device 200 using the existing LTE as an anchor. In addition, U-plain (user data) is transmitted and received by the NR between the small cell base station 100B and the terminal device 200. With such a configuration, the transmission and reception of the U-plain can be realized with higher throughput. In addition, a radio access network (5G RAN) is controlled by EPC190 via the S1 interface.

In particular, in the 5G mobile communication system, the use of communication using a radio signal (hereinafter, also simply referred to as "millimeter wave") having a frequency called a millimeter wave such as 28 GHz or 39 GHz is being studied. In addition, millimeter waves have a relatively large spatial attenuation, and when millimeter waves are used for communication, antennas with a high gain tend to be required. In order to realize such a requirement, in the 5G mobile communication system, it is considered to use the directional beam for communication between a base station and a terminal device by forming a directional beam by a technique so called beamforming. By using the technology, for example, it becomes possible to spatially multiplex communication between the base station and the terminal device in addition to multiplexing in time and frequency. With such a configuration, in the 5G mobile communication system, it is possible to increase the number of users who can simultaneously perform end-to-end communication at a very high data rate, and since the cell capacity will increase dramatically, it is expected that the service will be further broadband (enhanced mobile broadband (eMBB)).

(Overview of cell layout design)

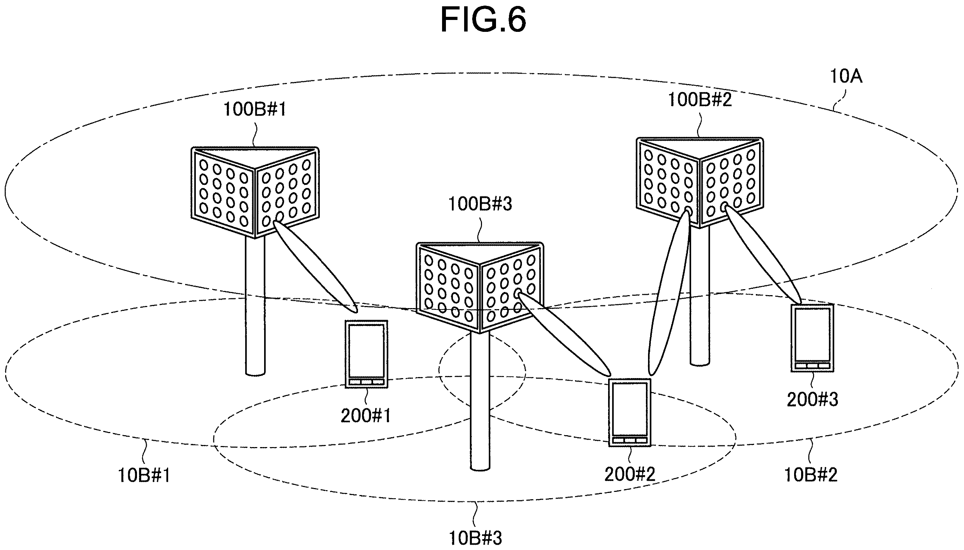

Here, an overview of an example of cell arrangement design in the 5G will be described with reference to FIG. 6. FIG. 6 is an explanatory diagram for describing an overview of an example of a cell arrangement design in 5G. In the example illustrated in FIG. 6, the existing cell 10A based on the LTE standard is used as an overlaid cell, and small cells 10B#1 to 10B#3 capable of communicating using millimeter waves within the cell 10A overlap to form a heterogeneous network (HetNet). Note that the small cells 10B#1 to 10B#3 indicate the small cells formed by the small cell base stations 100B#1 to 100B#3, respectively. Based on such a configuration, the transmission and reception of the U-plain (user data) is made between each of the small cell base stations 100B#1 to 100B#3 and each of the terminal devices 200#1 to 200#3 located in the small cells 10B#1 to 10B#3. This makes it possible to further improve the throughput related to the transmission and reception of the U-plain (user data).

(Beam management)

Next, a procedure of beam management (BM) in the 5G will be described in particular by focusing on the procedure for narrowing the beam used for the communication between the base station and the terminal device.

The 5G (NR) using the millimeter wave band is called FR2 (24.25G to 52.6GHz) from the frequency range in the specifications, and in TS38.101-2 (2018/09), specifications have been made for test items of wireless characteristics on the terminal device (5G terminal) side or the minimum requirements for the test items.

In the case of the NSA, for example, it is possible to acquire information on the timing or frequency required for synchronization of the 5G from the LTE side, which is the anchor, by exchanging C-plain (control information). This matter is specified as an RRC parameter in, for example, TS38.331 (2018/09).

In 5G (NR) of FR2, the coverage of one base station (for example, eNB, gNB, TRP, or the like) may be narrowed due to a path loss. Therefore, for example, by beamforming, the radio waves radiated from the antenna are concentrated in a desired direction to form a narrow beam width so as to have sharp directivity. By applying such control, it becomes possible to compensate for the path loss in the FR2 by the beamforming gain.

In addition, the 5G (NR) of FR2 adopts the TDD system, and performs ping-pong transmission communication with the same frequency together with a DL signal and a UL signal. Therefore, the beamforming function for compensating for the path loss in the FR2 described above may be required not only on the base station side but also on the terminal device (5G terminal) side.

In addition, as the operation of the FR2 system, many discussions and studies have been conducted on the beam management (BM) operation in RAN1.

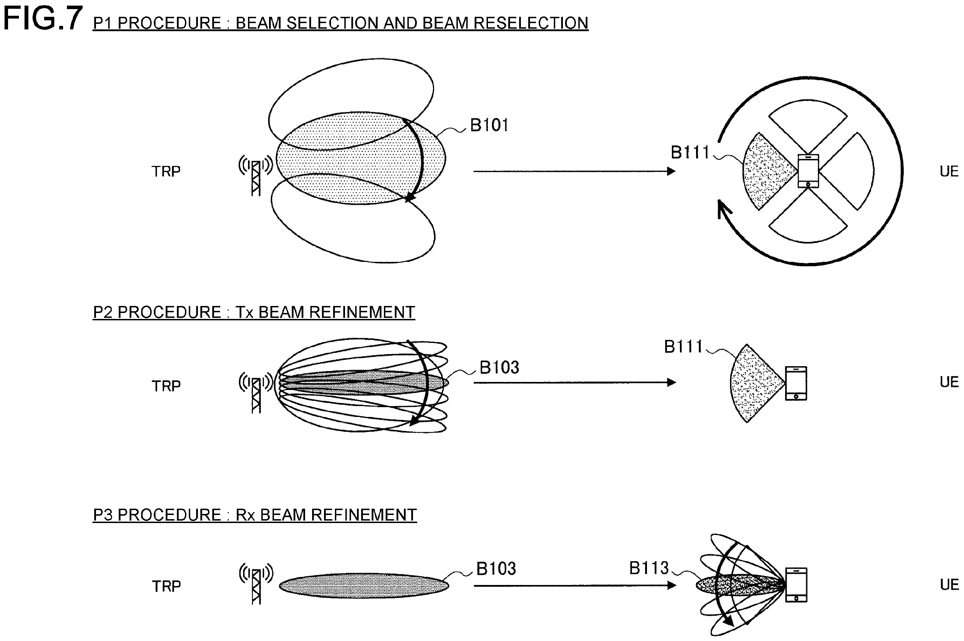

Here, the overview of the procedure of the beam management will be described with reference to FIG. 7. FIG. 7 is an explanatory diagram for describing an overview of the procedure of the beam management. In the 3GPP, as described above, the operation of the beam management (BM) represented by the P1, P2, and P3 procedures is defined as the procedure for narrow beam formation. By the P1, P2, and P3 procedures, beam refinement (BR) is performed between the base station and the terminal device.

The P1 procedure is defined by beam selection and beam reselection. In the P1 procedure, the operation of beam alignment at the time of initial access is basically assumed using a wide beam with a relatively wide beam width.

The P2 procedure is defined in Tx beam refinement. In the P2 procedure, the beam refinement (BR) is performed on a downlink (DL) Tx beam on the base station side, and an operation of performing beam correspondence between the narrow beam with a narrower beam width on the base station side and the beam on the terminal device side is assumed.

The P3 procedure is defined in Rx beam refinement. In the P3 procedure, the beam refinement (BR) is performed on the DL Rx beam on the terminal device side, and an operation of performing the beam correspondence between the narrow beam on the base station side and the narrow beam with the narrower beam width on the terminal device side is assumed.

<<3. Examination of application of beamforming technology>>

Subsequently, the technical problem of the system according to the present embodiment will be examined below, by focusing on the application of the beamforming technology.

As described above, in the 5G (NR) of FR2, it may be necessary to perform the beamforming on the terminal device (5G terminal) side in order to compensate for the path loss. That is, as the system operation of the FR2, it may be necessary to perform the beam management operation on the terminal device (5G terminal) side as well.

On the other hand, the number of beams formed by a plurality of antenna elements included in the antenna device mounted on the terminal device or the phase and power characteristics of the beam may depend on a form factor of the terminal device itself and the terminal design. As an example of specific factors, the characteristics of the antenna element of the antenna device mounted on the terminal device, how many antenna devices are provided per terminal device (5G terminal), at which position of the terminal the antenna device is arranged, what is the material of the matter used for the terminal itself and what is the design of the terminal, and the like may be mentioned.

Therefore, for each beam generated by each antenna element of each antenna device mounted on the terminal device itself, it may be necessary to control the phase and power related to the transmission of the radio signal in consideration of the influence of the factors unique to the terminal device (in other words, the factors unique to the antenna device) described above. Regarding the information related to such phase and power control, for example, a series of information obtained by measuring each beam in advance and associating each beam with the information acquired for the beam is stored in a predetermined storage area (for example, the storage unit 230 illustrated in FIG. 4) as a so-called lookup table (LUT). That is, the terminal device can reduce the influence of factors unique to the terminal device described above by controlling the phase or power related to the transmission of the radio signal from each antenna element included in the desired antenna device by using the information held in the LUT.

On the other hand, in order to generate the above-described LUT, for each beam that can be formed by the antenna device, the phase and power related to the transmission of the radio signal by each antenna element included in the antenna device at the time of forming the beam needs to be measured. When the terminal device includes four antenna devices, since it is necessary to measure the phase and power related to the transmission of the radio signal by each antenna element for each beam that can be formed by the antenna device for each antenna device, the measurement time of the data related to the control of the phase and the power for creating the LUT becomes relatively long. In such a situation where the measurement takes a long time, the frequencies of the IF signal (that is, the IF_V signal and the IF_H signal illustrated in FIG. 4), the LO signal, and the like are shifted due to the influence of the heat dissipation of each element (for example, an amplifier or the like) provided in the antenna device. That is, due to such a frequency shift, it may be difficult to accurately measure the phase and power of the radio signal transmitted by each antenna element when forming the beam.

As described above, the 5G (NR) using the millimeter wave band adopts the TDD method, and both the DL signal and UL signal communicate by the ping-pong transmission at the same frequency. Therefore, the beamforming function for compensating for the path loss in the FR2 described above may be required not only on the base station side but also on the terminal device (5G terminal) side.

In addition, as the operation of the FR2 system, it is necessary for the base station side and the terminal device (5G terminal) side to have the capability to align the spatial positions of the beams with each other. The capability to align the spatial position of the beam is called the beam correspondence (BC) in the 3GPP. That is, it is important that the terminal device (5G terminal) side in the FR2 has this capability in order to quickly and stably communicate with the base station side in the millimeter wave band. For reference, the capability of the beam correspondence described above is disclosed as a test item as a core specification that is the minimum requirement for UE RF characteristics in Section 6.6 Beam correspondence of TS38.101-2 of 3GPP.

The terminal device (5G terminal) can have the above-described beam correspondence capability by holding the LUT generated as described above that can be referenced by the antenna device provided by the terminal device (5G terminal).

On the other hand, as described above, since it takes a relatively long time to measure the phase and power related to the generation of the LUT, there is a problem in that heat is dissipated from the element included in the antenna device, and as a result, an error occurs in the measured value.

In view of the above circumstances, in the present disclosure, as an example of a technique capable of reducing the influence of errors due to the hardware configuration of the antenna device in a more preferable manner, in particular, a technique that makes it possible to generate the above LUT in a more preferable manner is proposed. Specifically, an example of a measurement system that suppresses the occurrence of errors due to frequency shifts due to the heat dissipation or the like of the above-described elements and enables the above-described LUT to be generated without complicated operations is proposed.

<<4. Example of measurement system related to generation of LUT>>

Here, in order to make the characteristics of the technique according to an embodiment of the present disclosure easier to understand, as an example of a method for verifying the radio frequency (RF) characteristics (for example, phase, power, etc.) of the terminal device, in particular, the over the air (OTA) test will be described below.

TR38.810 of 3GPP summarizes the results of studies on the over the air (OTA) test method of UE RF characteristics in the 5G (NR) of FR2. The idea of the OTA test methodology for the UE RF characteristics needs to meet the equivalence criteria for the distant world environment. As an example of the OTA test method of the UE RF characteristics, the following three methods may be mentioned.

- Direct far field (DFF)
- Indirect far field (IFF)
- Near field to far field transform (NFTF)

(DFF)

In the DFF method, the measurement system is configured so that the DUT (UE) and the measurement antenna are separated by a distance R, which is a far field in which the electromagnetic wave is directly regarded as a plane wave. The distance R is represented by the formula shown below as (Equation 1).

$$R > \frac{2D^2}{\lambda} \qquad\qquad \text{(Equation 1)}$$

In the above (Equation 1), R represents the minimum far-field distance. Further, $\lambda$ indicates the wavelength of the radio signal for which the RF characteristic is to be measured (that is, the wavelength of the radio signal corresponding to the frequency for which the RF characteristic is to be measured). In addition, D represents a diameter of the smallest sphere surrounding a radiating part of the DUT. As the value of D, for example, a diagonal length of the housing of the terminal device (5G terminal) is used. In general smartphones, the length of the diagonal line tends to be about 15 cm. Further, in the case of a tablet terminal, the length of the diagonal line tends to be about 30 cm. Based on the above, the formula for calculating the distance that can be regarded as the far field and the free space loss derived from the distance are disclosed in, for example, TR38.810 of 3GPP. In the DFF method, due to its characteristics, the size of the anechoic chamber, which can be regarded as a far field, tends to be relatively large, and the free space loss tends to be large.

(NFTF)

In the NFTF measurement system, after measuring the amplitude and phase on the surface (in this case, the spherical surface) around the DUT, the conversion from the near field to the far field is performed. Specifically, the far field pattern of the 3D is obtained by using the spherical wave extension of the modal analysis, and the conversion between the near field and the far field is based on the Huygens principle. The direct solution of the Helmholtz equation is obtained by applying boundary conditions at infinity from the DUT to the surface. The mode coefficient can be determined from the tangent field on the surface of the sphere using the orthogonality of the mode expansion. Details of this matter are disclosed in Annex F of TR38.810.

In the measurement of the NFTF, it is possible to measure a 3D pattern with a rotation of an azimuth angle (azimuth direction) by using a circular probe array. Further, by utilizing the electronic switching between the antenna elements of the probe array, it is possible to measure the point of the elevation angle (elevation direction) without rotating the DUT in the elevation angle plane.

In the NFTF method, the signal transmitted by the DUT is measured simultaneously using two probes. At this time, one probe corresponds to the probe for the measurement signal and the other corresponds to the probe for the reference signal. Based on such a configuration, the amplitude and absolute phase of the measurement signal are acquired by inputting the measurement results of the measurement signal and the reference signal by the above two probes to a phase recovery unit (PRU).

As described above, the NFTF method tends to complicate the measurement system due to the characteristic of using the PRF.

(IFF)

The IFF method indirectly constructs the far field environment by using a parabolic reflector conversion.

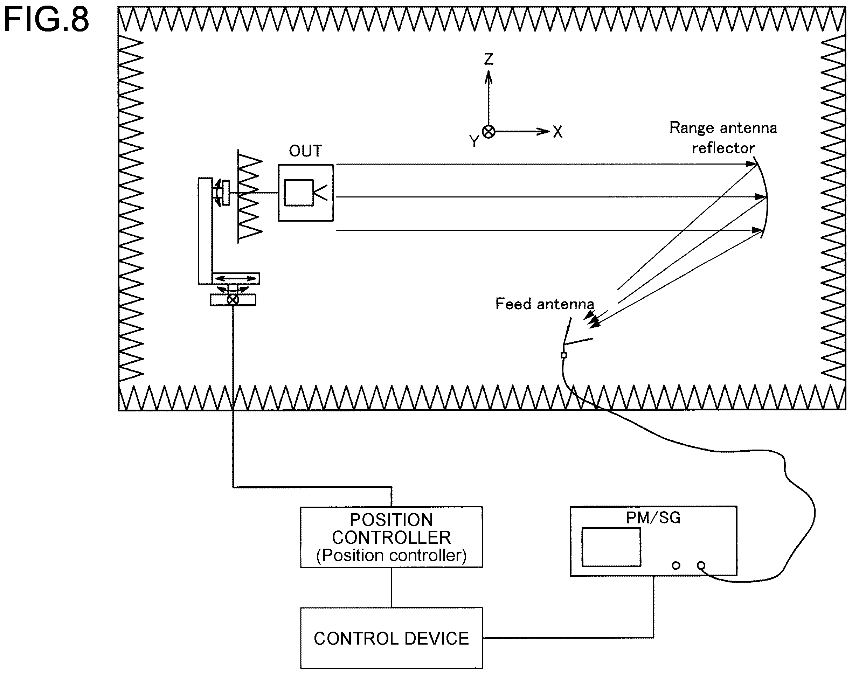

Such a configuration is known, for example, as a compact antenna test range (CATR). Here, an example of a measurement system to which the IFF method is applied will be described with reference to FIG. 8. FIG. 8 is an explanatory diagram for describing an example of a measurement system to which the IFF method is applied, and illustrates an example of the configuration of a so-called CATR measurement system (hereinafter, also simply referred to as "CATR").

The CATR illustrated in FIG. 8 has the following features.

- It is possible to provide a positioning system that has at least two degrees of freedom of rotation at the angle between the dual polarization measurement antenna and the DUT and maintains a polarization reference.
- It has been agreed that 3GPP TR38.810 can test testing items for EIRP, TRP, EIS, EVM, spurious emission, and blocking.
- Before performing a beam lock function (UBF), the measuring antenna probe functions as a link antenna to maintain a polarization reference to the DUT. On the other hand, when the beam is locked by the UBF, the link with the SS (gNB emulator) side is passed to the link antenna side, and the link antenna can maintain a reliable signal level with respect to the DUT.
- In a setup aimed at measuring UE RF characteristics in 1UL configuration NSA mode, it is possible to provide a LUT link to the DUT using a LTE link antenna.

Due to the features shown above, the CATR as illustrated in FIG. 8 is generally used as the standard measurement system for the over the air (OTA) test method for UE RF characteristics in the 5G (NR) of FR2. In the Tx measurement in the CATR setup, the DUT radiates a spherical wavefront to a collimator (a system that parallelizes radio waves) that is within the range of focusing a propagation vector that coincides with a bore site direction of a reflector on a feed antenna.

On the other hand, in the Rx measurement, the feeding antenna radiates the spherical wavefront to the reflector in the range where the radio waves are parallel in the direction of the DUT. That is, the CATR is a system that converts the spherical wavefront into a plane wavefront when the spherical wavefront is on the DUT side.

When designing the CATR, the following parameters are mainly considered to meet the requirements.

- Quiet Zone (QZ)
- Focal length
- Offset angle
- Position of feed antenna

Basically, a plane wave plane (with uniform amplitude and phase) is a measurement system guaranteed for a particular cylinder size. The size of the QZ mainly depends on the reflector, the taper of the feed antenna, and the design of the anechoic chamber. The details of the concept of QZ in the CATR and an example of the phase distribution in the QZ of the CATR designed for the QZ size are disclosed in TR38.810 of 3GPP, and therefore, detailed description thereof is omitted. A total phase variation in the QZ of the CATR is characterized by being extremely smaller than a phase variation (22.5°) for general DFF.

One of the features of the CATR is that the CATR of the NR RF FR2 requirement includes a link antenna to maintain the NR link that enables off-center beam measurements. Along with testing with the UE beam lock function (UBF), this link antenna makes it possible to measure the entire emission pattern of the UE RF characteristics at the 5G (NR) of FR2. Here, the overview of the measurement fixed order will be described below.

First, before UBF was performed, the antenna probe for measurement functions as the link antenna maintaining a polarization reference for the DUT. When a system simulator (SS) side and the terminal device (UE) side are in the CONNECTED state and are positioned in the Tx peak beam direction, and the Tx beam is beam-locked by the UBF, the above link is passed towards the link antenna, which maintains a reliable signal level for the DUT. Thereafter, it is possible to rotate the terminal device side and measure the entire radiation pattern without losing the connection with the system simulator.

From these features, by the beam lock test function on the link antenna and the terminal device side, the CATR can measure both on the center side of the beam and the off center of the beam in the beam measurement.

Also, in the setup aimed at measuring the UE RF characteristics in a non-standalone (NSA) mode using the 1UL setting, it is possible to provide the link on the LTE side to the DUT side by using the LTE link antenna that serves as an anchor. The LTE link antenna provides stable LTE signals without performing the accurate path loss or polarization control. The CATR is provided with such a LTE link antenna.

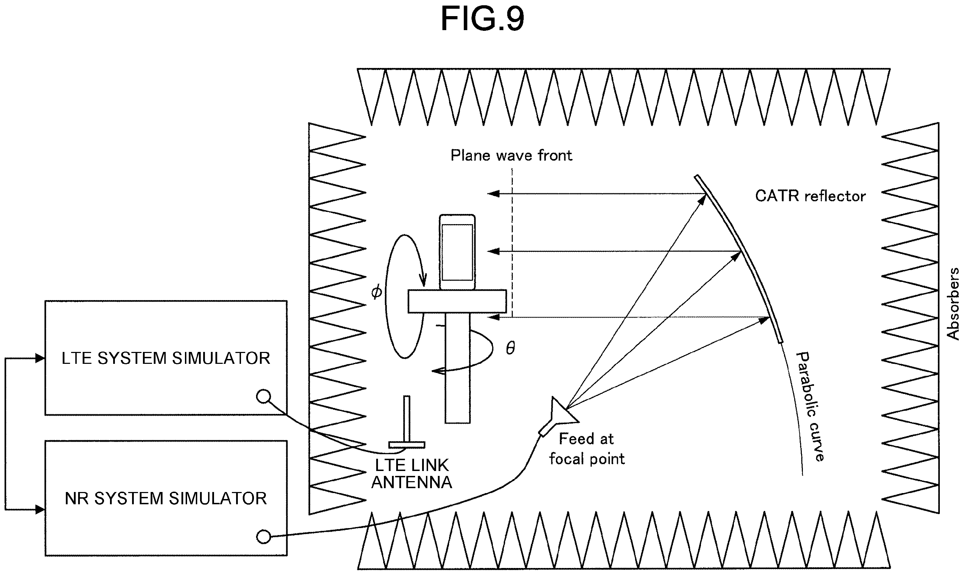

Here, an overview of an example of the EIPR measurement system using the CATR measurement system will be described with reference to FIG. 9. FIG. 9 is an explanatory diagram for describing an example of the EIPR measurement system using the CATR measurement system, and illustrates an example of the EIPR measurement system in the non-standalone state. In addition, a general measurement procedure will be described below.

First, the terminal device (UE) side that entered the test mode by the test SIM performs almost the same operation as during normal IA, and starts the search reception of the "SS Block" transmitted from the NR system simulator (SS) side using the antenna module group provided on the terminal device side. Also, in Rel-15, for the RSRP received by each antenna module, the "threshold information" of the "SS Block" to be selected and the "Tx transmission power information" on the gNB side are transmitted from the LTE side of the anchor to the terminal device.

On the other hand, in the standalone (SA), since the "NR-SIB" information is carried to RMSI, the above "SS Block" can be received by specifying a position on "TF Mapping" from a common search space (CSS). By the RSRP measurement, based on the "SS Block" that meets the threshold, a PRACH machine (RO) and the like which is the timing to transmit "path loss (PL) estimate", optimal "SS Block" in the area cell for Msg1 transmission, (spatially) QCLed "PRACH resource" corresponding to the "SS Block", and the "PRACH resource" can be selected.

In the FR2, since the TDD method is adopted and the "Tx-Rx Reciprocity characteristics" are sufficiently established in the anechoic chamber, so the direction in which the RSRP measurement result is the largest can be determined as the beam peak direction on the Tx-Rx side. It is agreed in 3GPP that the beam direction of PRACH is (spatially) QCLed with the "SS Block" which has the largest RSRP value.

The terminal device (5G terminal) side uses the test SIM, but operates in almost the same way as during the normal IA, receives the SS Block signal from the NR system simulator, and uses the "SIB1" information from the LTE side as an EN-DC (NSA) anchor. Then, the terminal device performs a beamforming (BF) operation so that the RSRP value of the "SIB1" information is maximized.

Specifically, the terminal device controls the direction in which the peak beam is directed so as to satisfy the beam correspondence (BC) characteristic from the optimum antenna module.

Here, by further fine tuning the 3D positioner as a measurement system, the Tx-Rx side beam peak direction is detected. When transitioning to the "CONNECTED" state, the DCI format increases the transmission output until the Tx peak beam is formed in the direction specified above by "UL RMC setting" and "Power control by TPC", and then the UBF (beam lock) is performed. Note that the above measurement is performed on each of V polarization and H polarization, for each frequency targeted by the FR2.

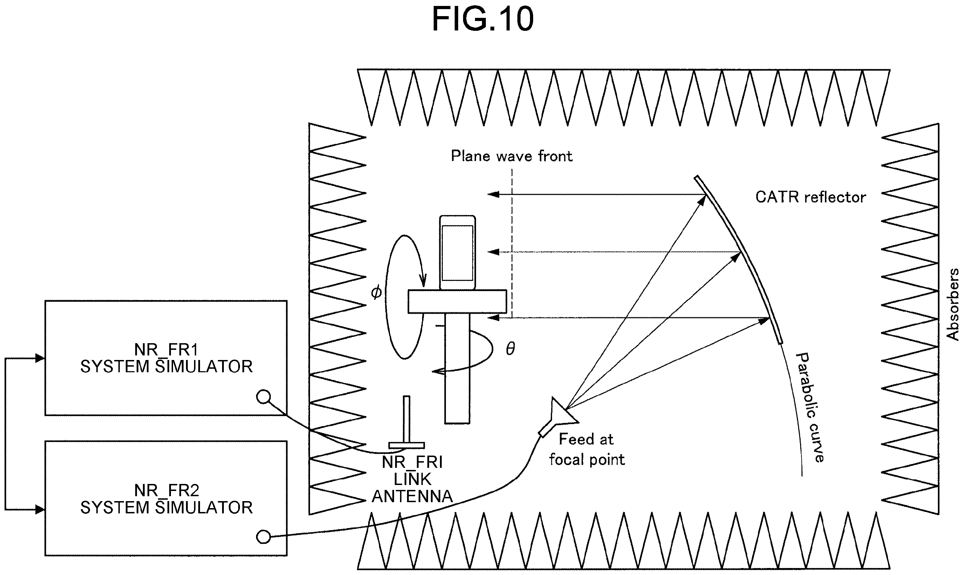

FIG. 10 is an explanatory diagram for describing an example of the EIPR measurement system using the CATR measurement system, and illustrates an example of the EIPR measurement system in the standalone state. As described above, the CATR measurement system with the NR RF FR2 requirements includes a link antenna to maintain the NR link to enable the off center beam measurement. That is, in the measurement of the UE RF characteristics in the non-standalone (NSA) mode using the 1UL setting, by using the link antenna for the LTE that becomes the anchor in advance, the "CONNECTED" state is maintained for the terminal device (5G terminal) side and the LTE that becomes the anchor, and the link with the LTE system simulator (SS) side is maintained.

On the other hand, when measuring the UE RF characteristics in the stand-alone (SA) mode, it is reasonable to think that the terminal device (5G terminal) side supports both the Sub6 (FR1) and millimeter wave band (FR2) bands. That is, in the measurement of the UE RF characteristics in the non-standalone (NSA) mode using the 1UL setting described above, by using the link antenna for the LTE that becomes the anchor in advance, the terminal device (5G terminal) side and the system simulator on the LTE side that serves as an anchor use the same idea that the "CONNECTED" state is maintained.

The 5G (NR) of FR1 in the 3GPP specifications operates in the same frequency band (for example, 7.125GHz or less) as the LTE. Therefore, in general, the antenna on the terminal device (5G terminal) side can have an omni pattern. In other words, in the measurement of the UE RF characteristics in the stand-alone (SA) mode, a call connection is made to the 5G (NR) side of FR1 with the NR system simulator SS side until it reaches the "CONNECTED" state. As a result, it is possible to maintain the link with the NR system simulator side for FR1 inside the measurement system of the anechoic chamber as in the LTE side as the anchor of the non-standalone (NSA) mode. That is, it is possible to measure the off center beam of the UE RF characteristics in the 5G (NR) of FR2 as in the non-standalone (NSA) mode.

As described above, by using the CATR measurement system, the EIRP measurement and the like can be performed in both the non-standalone (NSA) mode and the stand-alone (SA) mode.

As illustrated in FIG. 9, a common reference CLK (Ref_CLK) is used between the NR system simulator side for the FR2 where the beam forming is performed and the measuring instrument on the LTE system simulator side which is the anchor in the NSA to perform the clock synchronization, so it is possible to completely synchronize the frequency between the above two measuring instruments. As described above, in FIG. 10, it is possible to configure the same mechanism between the NR system simulator side for the FR2 and the measuring instrument on the NR system simulator side for FR1 which is initially in the "CONNECTED" state in the stand-alone (SA).

As described above, in the measurement system of the anechoic chamber, the terminal device (5G terminal) side with the omni-pattern antenna is stable with respect to the measuring instrument on the LTE system simulator side and the NR system simulator side for FR1, it is possible to maintain a stable link with the measuring instrument side. Therefore, a channel estimation (CE) function and a frequency tracking function of the base band (BB) modem inside the terminal device (5G terminal) operate autonomously, and as a result, the frequency shift will be autonomously compensated by the terminal device itself even in situations where the frequency shifts may occur due to the influence of heat dissipation or the like due to the longer measurement time. However, both TS36.101, which is a specification describing the core specifications of LTE RF characteristics, and TS38.101, which is a specification describing the core specifications of 5G (NR) RF characteristics define that when the "CONNECTED" state is maintained, the core specifications of the frequency error are within ± 0.1 PPM.

<<5. Technical Feature>>

Next, technical features of the system according to an embodiment of the present disclosure will be described.

(Overview)

As described above, by using the CATR measurement system, for the measuring instrument on the LTE system simulator side or the NR system simulator side for FR1 in the anechoic chamber measurement system, the terminal device (5G terminal) side with the omni-pattern antenna can stably maintain the link with the measuring instrument side. That is, by the channel estimation (CE) function and the frequency tracking function of the base band (BB) modem inside the terminal device (5G terminal), the frequency shift will be autonomously compensated by the terminal device itself even in situations where the frequency shifts may occur due to the influence of heat dissipation or the like due to the longer measurement time.

In the system according to the present embodiment, by utilizing the advantages of the CATR measurement system described above, the mechanism which suppresses the influence of the frequency shift due to the heat dissipation (for example, phase shift of radio signal), and the mechanism for the generation of the above-described LUT without complicated operations is provided.

As described above, when performing the conformance test of the UE RF characteristics in the 3GPP, the "black box approach" that does not declare the location of the antenna device on the terminal device (5G terminal) side is currently agreed on in RAN4 and RAN5. On the other hand, when the terminal device (UE) vendor side generates the LUT unique to the antenna device provided in the terminal device, the position where the antenna device is arranged can be clearly grasped. In the system according to the present embodiment, such a characteristic is used to generate the LUT unique to the antenna device provided in the terminal device. Note that in the following, for convenience, the terminal device shall be provided with four antenna devices as in the example illustrated in FIG. 7. Further, regarding the antenna device, as in the example illustrated in FIG. 4, it is assumed that each antenna element is configured to be capable of transmitting and receiving the V polarization and the H polarization, and the four antenna elements are configured in an array.

As a method of measuring the phase and power of a radio signal which is a millimeter wave for each beam formed by each antenna device provided in the terminal device, a method using a vector network analyzer (VNA) can be mentioned. In this case, for example, a hole is made in the housing of the terminal device (5G terminal), a cable is connected to each antenna device provided in the terminal device via the hole, and various signals related to the transmission of the radio signal (for example, the IF_V polarization signal, the IF_H polarization signal, and the signal corresponding to the RFLO signal in FIG. 4) are input from the VNA via the cable. With such a configuration, it is possible to more accurately measure the phase and power related to the transmission of the radio signal by each antenna device included in the terminal device.

However, in the method using the VNA described above, since the hole is made in the housing of the terminal device, and a cable is connected to each antenna device via the hole, the measurement data is likely to fluctuate depending on how to make the hole and how to route the cable. In addition, there is a possibility that human error may occur in the operation of making a hole in the housing of the terminal device or the operation of routing the cable, and there is a possibility that such a mistake may affect the measurement result. In addition, since each of the above operations needs to be performed so as not to affect the rotation measurement system of the 3D positioner, the complicated and delicate operation is required, which is a very inefficient method even in the development of the terminal vendor side.

In the present disclosure, it is assumed that the BB modem side of the 5G (NR) has a setting to operate in a special test mode as a development test function, for example. As a specific example, the case where the LUT for the millimeter wave (FR2) is created for the terminal device (5G terminal) in the non-standalone (NSA) mode and the standalone (SA) mode will be described. For example, in the case of the NSA mode, the "CONNECTED" state is maintained with the system simulator side for LTE that becomes the anchor, and then a test mode for measuring the phase and power of the radio signal transmitted by the antenna element included in the antenna device for each beam formed by each antenna device included in the terminal device is set for each of the measuring instrument side and the terminal device (5G terminal) side of the CATR measurement system. In addition, in the case of the SA mode, the "CONNECTED" state is maintained with the NR system simulator side for FR1 as an Inter-band CA, and then a test mode for measuring the phase and power of the radio signal transmitted by the antenna element included in the antenna device for each beam formed by each antenna device included in the terminal device is set for each of the measuring instrument side and the terminal device (5G terminal) side of the CATR measurement system.

In the state where the link serving as the anchor is maintained, as a signal for operating the antenna device, the signal is output from the BB modem side of 5G (NR) using the CW (Continuous Wave) signal, which is an unmodulated carrier, in the same manner as the signal output from the VNA described above.

(Example of configuration of measurement system)

In the present disclosure, it is assumed that the phaser (phase shifter) inside the antenna device for millimeter waves is assumed to be operated according to the IC design, and the phase and power of the radio signal transmitted by the antenna element included in the antenna device are measured for each beam formed by each antenna device. As described above, the QZ of the CATR has a cylindrical shape, and the amount of phase fluctuation in the QZ is smaller than the amount of phase fluctuation in the case of DFF. For example, a CATR measurement system having a QZ with a diameter of 30 cm has already been put into practical use. In addition, a vector signal analyzer (VSA) used for phase and amplitude (power) measurement is also equipped with the latest high-speed ADC, and a measuring instrument that can directly measure frequencies up to 85 GHz with a BW (bandwidth) of up to 2 GHz without the need for an upconverter has already been put into practical use.

In the present disclosure, the radio signal phase and amplitude (power) transmitted by each of the antenna elements included in the antenna device are measure for each beam that can be formed by the antenna device mounted on the terminal device (5G terminal) by using the VSA to which the above-described high-speed ADC is applied in the CATR measurement system. Further, in this case, the above measurement is performed while changing the attitude of the terminal device (in other words, the antenna device) in the azimuth direction and the elevation direction with a measurement grid having a predetermined step size.

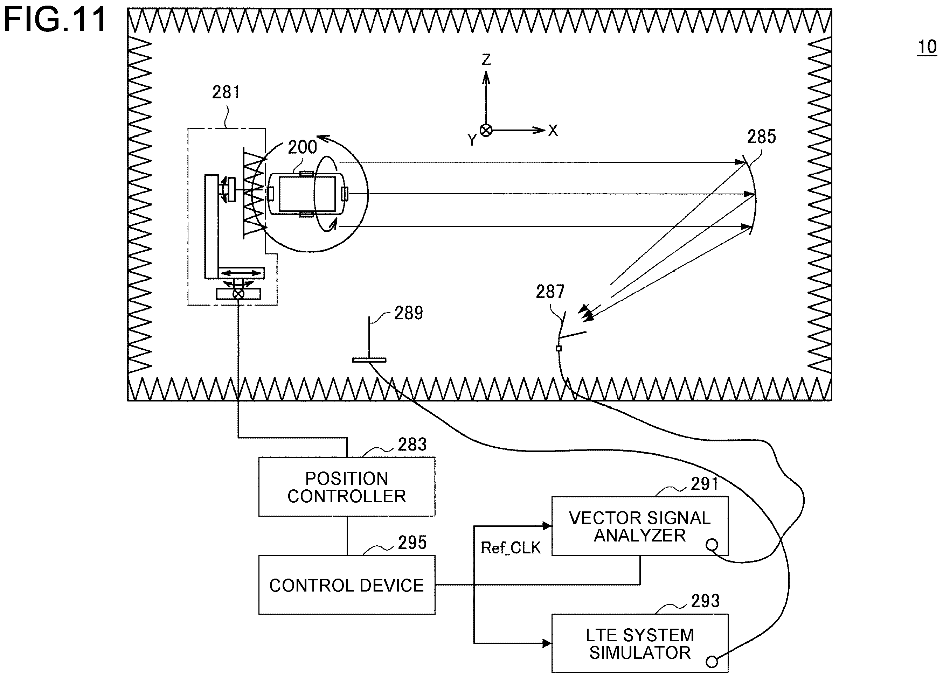

For example, FIG. 11 is an explanatory view for describing an example of a configuration of an information processing system according to the present embodiment. As illustrated in FIG. 11, the information processing system (that is, the measurement system) 10 according to the present embodiment includes a terminal device 200, an attitude control device 281, a position controller 283, a reflector 285, a feed antenna 287, an LTE link antenna 289, a vector signal analyzer (VSA) 291, an LTE system simulator 293, and a control device 295.

The attitude control device 281 includes a support portion configured to be able to support the terminal device 200. Further, the support portion is supported by a member configured to be rotatable with respect to each of a plurality of rotation shafts different from each other. Based on such a configuration, the attitude of the support portion is controlled by rotationally driving the member by driving an actuator or the like. That is, the attitude of the terminal device 200 supported by the support portion is controlled. The operation of the attitude control device 281 is controlled by, for example, the position controller 283 described later.

The reflector 285 corresponds to a reflector for indirectly forming a far field environment in the IFF measurement system. The reflector 285 is arranged so as to face the terminal device 200 supported by the attitude control device 281 at a predetermined distance. Based on such a configuration, the reflector 285 reflects the radio signal transmitted from the antenna device included in the terminal device 200 toward the feed antenna 287.

The feed antenna 287 receives the radio signal transmitted by the antenna device included in the terminal device 200 and then reflected by the reflector 285, and outputs the reception result to the vector signal analyzer 291.

The LTE system simulator 293 and the LTE link antenna 289 serve as the LTE system simulator and the LTE link antenna described with reference to FIG. 9. That is, by using the LTE link antenna 289 as an anchor and maintaining the "CONNECTED" state for the terminal device 200 and the LTE as the anchor, the link between the terminal device 200 and the LTE system simulator 293 is maintained. That is, the LTE system simulator 293 operates autonomously so as to have a frequency error within $\pm$ 0.1 PPM as described above by performing wireless communication (LTE) with the terminal device 200 via the LTE link antenna 289, and as a result, it is possible to solve the problem of the phase measurement due to the frequency shift due to heat dissipation and the like of the element provided in the antenna device. In addition, the LTE system simulator 293 can also notify the vector signal analyzer 291 of information on the control of the terminal device 200 by supplying a control signal according to the control content of the operation of the terminal device 200 to the vector signal analyzer 291.

As a specific example, from the LTE system simulator 293 side, when the "CONNECTED" state is maintained, since demodulation RS (DMRS) is always transmitted downlink at a predetermined density in the payload data of cell specific RS (CRS) and PDSCH on the signal format defined in the 3GPP specification, it is possible to autonomously compensate for frequency deviation on the terminal device 200 side. As described above, since it takes a relatively long time to measure the phase and power, and therefore, the frequency shift occurs due to the heat dissipation or the like of the element provided in the antenna device, there is a risk that the frequency shift occurs and there are errors in the resulting phase measurements.

However, on the terminal device 200 side in which the "CONNECTED" state is maintained, as described above, it is possible to autonomously compensate for the frequency shift by receiving RS signals that are known to each other. In addition, the LTE system simulator 293 and the vector signal analyzer 291 are both supplied with the same reference clock (Ref_CLK) in the measurement system. It can be seen from this above-described measurement system that the vector signal analyzer 291, the LTE system simulator 293, and the terminal device 200 are always compensated to be synchronized in both the frequency domain and the time domain. In the terminal device 200, under the special test mode state for the LUT generation, the CW signal, which is an unmodulated carrier, is output from the 5G BB modem side to each of the mounted antenna devices to become an IF_V polarization signal and an IF_H polarization signal. Further, under the special test mode state for the LUT generation, the transmission timing can be recognized by the entire measurement system in time synchronization. That is, it can be seen that it is possible to perform the synchronization with the timing related to the transmission of the CW signal, which is the unmodulated carrier as the test mode signal, between the terminal device 200 and the vector signal analyzer 291.

The vector signal analyzer 291 acquires the reception result of the radio signal from the feed antenna 287 and measures the phase and amplitude of the radio signal. As described above, since the entire measurement system is time-synchronized, the vector signal analyzer 291 can always recognize the transmission timing of the CW signal, which is the unmodulated carrier as the test mode signal by the terminal device 200. Of course, when the vector signal analyzer 291 can measure the phase of the CW radio signal based on the reception result of the CW signal which is the unmodulated carrier, the method is not limited to the above-described example. Then, the vector signal analyzer 291 outputs the measurement result of the phase and amplitude of the radio signal to the control device 295.

The position controller 283 controls the attitude of the terminal device 200 supported by the support portion of the attitude control device 281 by controlling the operation of the attitude control device 281. This controls the terminal device 200 with respect to the reflector 285. That is, with the control of the attitude control device 281 by the position controller 283, one of the plurality of antenna devices provided in the terminal device 200 is controlled so as to face the reflector 285, and the attitude of the antenna device with respect to the reflector 285 is controlled. By using such a configuration, for example, it is possible to selectively switch the antenna device facing the reflector 285 (in other words, the antenna device that transmits the radio signal toward the reflector 285).

The control device 295 controls the operation related to the measurement of the phase and amplitude of the radio signal transmitted from the antenna device of the terminal device 200, and generates the LUT unique to the antenna device based on the measurement result.

Specifically, the control device 295 controls the operation of the attitude control device 281 on the position controller 283 so that the antenna device to be measured among the plurality of antenna devices included in the terminal device 200 faces the reflector 285. Further, in this case, the control device 295 may cause the position controller 283 to control the operation of the attitude control device 281 so that the attitude of the antenna device with respect to the reflector 285 is controlled according to the direction in which the antenna device forms a beam.

Further, the control device 295 instructs the vector signal analyzer 291 to perform the operation related to the measurement of the phase and amplitude of the radio signal transmitted by the target antenna device. In response to the instruction, the vector signal analyzer 291 operates in cooperation with the LTE system simulator 293 to execute a series of processes related to the above-described measurement.

When the control device 295 acquires information according to the phase and amplitude measurement results from the vector signal analyzer 291, the control device 295 associates the information with the information on the antenna device set as the measurement target at that time or the information (in other words, information on the direction in which the directivity of the beam is directed) on the attitude of the antenna device, and thus generates the LUT. The details of the operation related to the series of measurements described above and the operation related to the generation of the LUT according to the result of the measurement will be described later.

Further, the control device 295 corresponds to an example of the "information processing device" related to the generation of the LUT.

(Measurement flow)

Subsequently, a series of operation flows related to the measurement of the phase and amplitude of the radio signal transmitted from the antenna device for each antenna device included in the terminal device 200 will be described.

As described above, the vendor side of the terminal device can grasp the arrangement location of the antenna device on the terminal device (5G terminal) side. Therefore, for example, the attitude of the antenna device can be finely adjusted so that the measured value of the power of the beam formed by the antenna device by the vector signal analyzer 291 is maximized.

As a specific example, in a CATR measurement system having a QZ with a diameter of 30 cm, when the phaser (phase shifter) is set to 0°, the beam formed by the antenna device is assumed to have a broad beam width. Even in such a case, following the visual alignment according to the radiation pattern of the antenna device, the attitude of the antenna device (in other words, the terminal device 200) is adjusted based on the measured value of the vector signal analyzer 291, so it is possible to specify the position where the power of the beam is maximized. That is, in this case, the attitude can be determined, for example, as the reference position of the antenna device at "Phase Shifter = 0°".

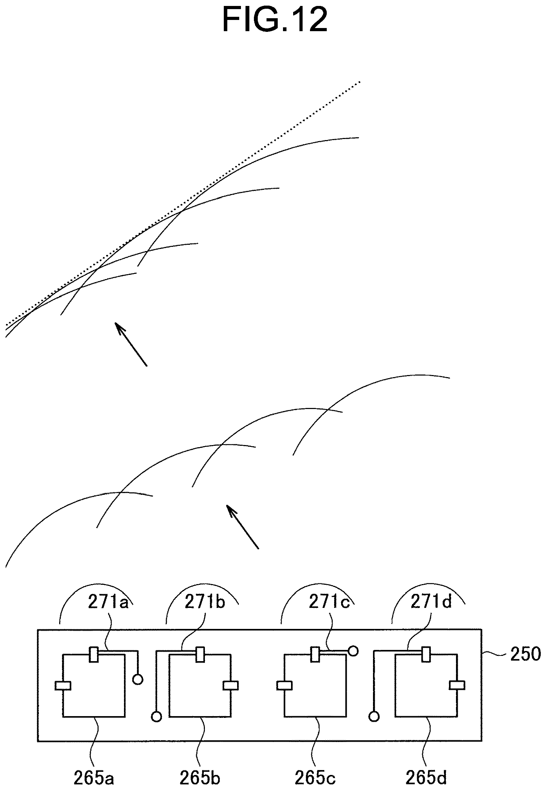

Here, an example of the configuration of the antenna device to be measured will be described with reference to FIG. 12. FIG. 12 is an explanatory view for describing an example of a configuration of the antenna device included in the terminal device according to the present embodiment. The antenna device 250 illustrated in FIG. 12 includes antenna elements 265a to 255d configured as a patch antenna (plane antenna). In the following description, when the antenna elements 265a to 255d are not particularly distinguished, the antenna elements 265a to 255d may be referred to as "antenna element 265". The antenna element 265 is configured to be capable of transmitting the V polarization and the H polarization. Further, reference numerals 271a to 271d schematically indicate wiring for transmitting an electric signal related to transmission of a radio signal to each feeding point of the antenna elements 265a to 255d.

It is difficult to measure the absolute phases of the radio waves (radio signals) emitted by each of the antenna elements 265a to 255d with the vector signal analyzer 291. Due to such characteristics, in the information processing system 10 according to an embodiment of the present disclosure, any one of the antenna elements 265a to 255d is set as the reference antenna element 265. Then, in the information processing system 10, the phase and power of the radio signal measured for the reference antenna element 265 are set as reference values related to the measurement of the phase and power of the radio signal for the other antenna element 265. Based on such a setting, for the other antenna element 265, the measurement values of the phase and power are acquired as deviation measurements (that is, relative measurement values to the reference value) with respect to the reference value. Note that the method of determining the reference antenna element 265 (for example, antenna elements 265a to 255d) from the plurality of antenna elements 265 included in the antenna device 250 is not particularly limited. In this description, it is assumed that the antenna element 265b (hereinafter, also referred to as "patch 2") is set as a reference. Note that the antenna element 265 included in the reference antenna element 265b corresponds to an example of the "first antenna element". Further, the information corresponding to the reference value corresponds to an example of the "first information".

First, the radio signal is transmitted from the antenna element 265b (patch 2), and the vector signal analyzer 291 measures the phase and amplitude of the V polarization of the radio signal. The measurement results of the phase and amplitude (power) are retained as reference values. In this case, it is assumed that the setting of the CATR measurement system or the BB modem side of 5G (NR) are controlled in advance so that the polarization surface of the antenna element 265 is used for the radiation signal of the V polarization.

Next, the radio signal is transmitted from the antenna element 265a (hereinafter, also referred to as "patch 1"), and the vector signal analyzer 291 measures the shifts of the phase and amplitude (power) of the V polarization of the radio signal with respect to the reference value. Similarly, the radio signal is transmitted to the antenna element 265c (hereinafter, also referred to as "patch 3"), and the antenna element 265d (hereinafter, also referred to as "patch 4"), and the vector signal analyzer 291 measures the shift of the phase and amplitude (power) of the V polarization of the radio signal with respect to the reference value. Note that an antenna element 265 other than the reference antenna element 265b, such as the antenna element 265a, corresponds to an example of the "second antenna element". Further, the information according to the measurement results of the shifts of the phase and amplitude (power) corresponds to an example of "second information" on the antenna element 265a.

Note that when performing the above measurement for each antenna element 265, the other antenna element 265 may be invalidated. That is, the above measurement may be performed on each antenna element 265 while sequentially validating each of the antenna elements 265b, 255a, 255c, and 255d.

Next, the above measurement is performed on the H polarization in the same manner. Specifically, the radio signal is transmitted from the antenna element 265b and the vector signal analyzer 291 measures the phase and amplitude of the H polarization of the radio signal. The measurement results of the phase and amplitude (power) are retained as reference values. Next, the radio signal is transmitted to each of the antenna elements 265a, 255c, and 255d, and the vector signal analyzer 291 measures the shifts of the phase and amplitude (power) of the H polarization of the radio signal with respect to the reference value.

As described above, the phases and amplitudes of the V polarization and the H polarization are measured for the antenna elements 265a to 255d included in the target antenna device 250. With such measurements as one set, the attitude of the antenna device 250 is adjusted for each measurement grid having a predetermined step size in the azimuth direction and the elevation direction, and the adjustment is performed for each attitude. That is, for one antenna device, the measurement results of the phases and amplitudes of the V polarization and the H polarization for the antenna elements 265a to 255d are acquired for each attitude in the azimuth direction and the elevation direction. Further, as described above, the measurement results acquired at this time include the measurement results of the phases and amplitudes (power) of the V polarization and the H polarization transmitted from the reference antenna element 265b, and the measurement results of the shifts of the phases and amplitudes of the V polarization and the H polarization transmitted from each of the antenna elements 265a, 255c, and 255d, using the measurement result as the reference value.

Based on the measurement results obtained as described above, the LUT unique to the target antenna device 250 is generated.

Further, by sequentially performing the series of measurements described above for each antenna device 250 included in the terminal device 200, it is possible to generate the LUT unique to the antenna device 250 for each antenna device 250.

(Generation of LUT)

Subsequently, the generation of the LUT using the result of the above-described measurement will be described in detail below.

As described above, the antenna device 250 illustrated in FIG. 12 is configured to be capable of transmitting the V polarization and the H polarization, and includes four antenna elements 265. Further, the antenna device 250 is constituted by each TXRU (Tx & Rx chain) including a plurality of antenna elements (for example, four antenna elements) as in the example described with reference to FIG. 4.

On the other hand, as illustrated in the example illustrated in FIG. 12, in the antenna device 250, a line routing (feed line) to the feeding point of each antenna element 265 occurs due to the influence of size restrictions in the configuration and the like. Further, form factors, peripheral members, materials, and the like of the terminal device 200 itself may differ depending on the position at which the antenna devices 250 for millimeter waves are arranged in the terminal device 200.

In order to have the ability to align the spatial position of the beam (BC capability) between the base station side and the terminal device (5G terminal) side, for example, a LUT unique to the terminal device that depends on the conditions shown below is required.

- Characteristics of the antenna element of the antenna device
- Number of antenna devices,
- Position where the antenna device is installed
- Materials and designs applied to the terminal device

On the other hand, by using the above-described LUT, the shift of the phase and amplitude (power) of the radio signal due to the following factors is compensated, and the spatial alignment of the beam can be possible as originally assumed BC capability.

- Influence of feed line routing on antenna devices
- Influence of installation position of antenna device
- Influence of material or design applied to the terminal device

For example, FIG. 12 illustrates the principle of controlling (beam steering) the spatial position of the beam in the assumed direction. As illustrated in FIG. 12, there is no special need for absolute phases and amplitudes (power) values for the radio signals which are millimeter waves transmitted from each of the four antenna elements 265, and as illustrated as a configuration in FIG. 4, in each TXRU (Tx & Rx chain), it is possible to individually control the phase or amplitude (power) values for each antenna element 265. Therefore, when the information on the relative phase and amplitude (power) between the four antenna elements 265 is known, during the beam steering, it is possible to compensate the beam formed by beamforming so that it becomes a coherent plane wave in the expected direction.

In the measurement procedure described above, the interval of the measurement grid is determined with the trade-off of the total measurement time and the accuracy (in other words, the accuracy of the compensation of the phase and amplitude based on the LUT) related to the formation of the beam by each antenna device provided in the terminal device. As a specific example, when measuring the phase and power of the radio signal, which is a millimeter wave, for each antenna element included in each antenna device included in the terminal device, with a measurement grid having a step size of 3°, in proportion to the number of measurement points, the accuracy of beam formation during beamforming improves, but the measurement time becomes longer. On the other hand, when measuring the phase and power of the radio signal, which is a millimeter wave, for each antenna element included in each antenna device included in the terminal device, using a measurement grid with a step size of 10°, by reducing the number of measurement points, the accuracy of beam formation during beamforming is reduced, but the measurement time becomes shorter.

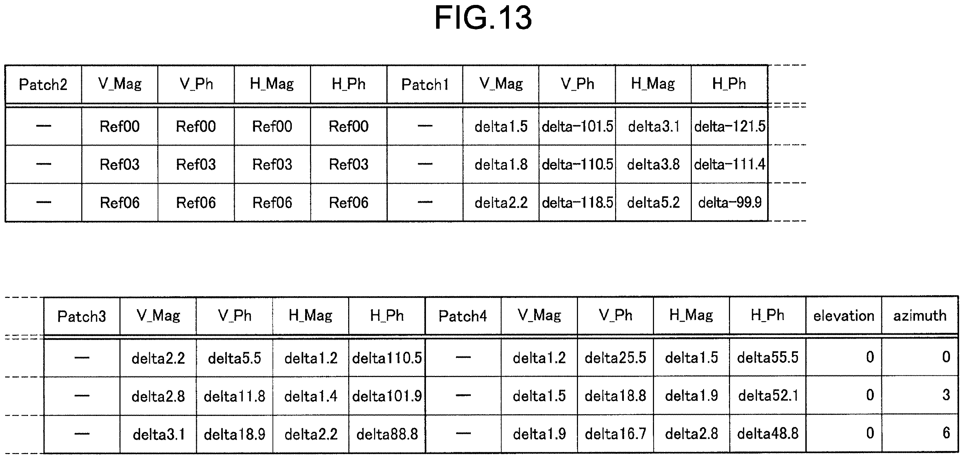

As an example, a case where the phase and power of the radio signal are measured for each antenna element included in each antenna device included in the terminal device by the measurement grid having a step size of 3° will be described. For example, FIG. 13 is a diagram illustrating an example of the measurement results of the phase and power of the antenna device related to the generation of the LUT according to the present embodiment. In the example illustrated in FIG. 13, the measurement result of the antenna element 265b (patch 2) among each antenna element 265 of the antenna device 250 illustrated in FIG. 12 is set as a reference value. Further, in the example illustrated in FIG. 13, each of the cases where the attitude of the antenna device 250 is changed and then the angle in the azimuth direction is set to 0°, 3°, and 6° is measured with the measurement grid with the step size set to an angle of 3°.

As in the example illustrated in FIG. 7, when the terminal device includes a plurality of antenna devices, the measurement data as illustrated in FIG. 13 is acquired for each antenna device by performing the above-described measurement for each antenna device.

(Measurement of phase and amplitude)

Here, an example of a method of measuring phases and amplitudes (power) of each antenna device for acquiring the measurement data as illustrated in FIG. 13 will be described in detail below.

As described above, in the information processing system according to the present disclosure, any one of the plurality of antenna elements 265 included in the antenna device 250 is set as the reference antenna element. Then, each antenna element 265 is sequentially validated, a radio signal which is a millimeter wave is transmitted, and then the phase and amplitude (power) of the radio signal are measured. In addition, in this case, the measurement result of the phase and amplitude (power) of the reference antenna element 265 is used as a reference value, and the shifts of the phase and amplitude (power) of the other antenna element 265 from the reference value are measured.

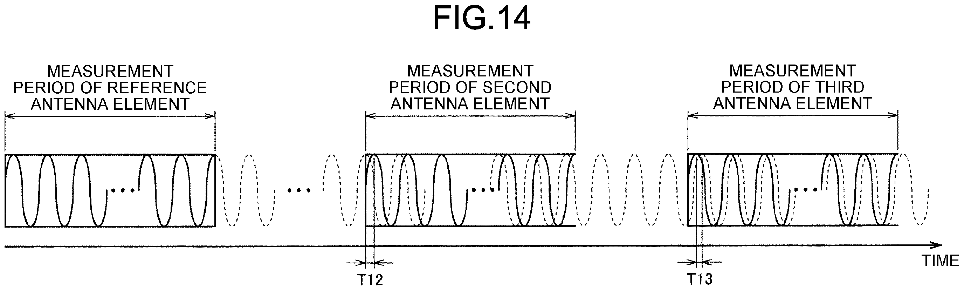

For example, FIG. 14 is an explanatory diagram for describing a method of measuring a phase of a radio signal which is a millimeter wave in the information processing system according to the present embodiment. As illustrated in FIG. 14, in the first measurement period, a radio signal which is a millimeter wave is transmitted from the reference antenna element, and the radio signal is taken into the vector signal analyzer 291.

Next, in the second measurement period, the radio signal which is the millimeter wave is transmitted from any of the other antenna elements (hereinafter, also referred to as "second antenna element") other than the reference antenna element (in other words, the antenna unit), and the radio signal is taken into the vector signal analyzer 291. In this case, the vector signal analyzer 291 compares the radio signal which is the millimeter wave taken into the second antenna element with the radio signal which is the millimeter wave taken into the reference antenna element on the time axis, thereby calculating a phase difference T12. That is, the phase difference T12 corresponds to the relative phase difference between the radio signals which are millimeter waves transmitted from each of the reference antenna element and the second antenna element. Then, the calculated phase difference T12 is held as the measurement data of the phase for the second antenna element.

Next, in the third measurement period, the radio signal which is the millimeter wave is transmitted from any other of the other antenna elements (hereinafter, also referred to as "third antenna element") other than the reference antenna element (in other words, the antenna unit), and the radio signal is taken into the vector signal analyzer 291. In this case, the vector signal analyzer 291 compares the radio signal which is the millimeter wave taken into the third antenna element with the radio signal of the millimeter wave taken into the reference antenna element on the time axis, thereby calculating a phase difference T12. That is, a phase difference T13 corresponds to the relative phase difference between the radio signals which are millimeter waves transmitted from each of the reference antenna element and the third antenna element. Then, the calculated phase difference T13 is held as the measurement data of the phase for the third antenna element.

As described above, each antenna element (antenna unit) included in the antenna device is sequentially validated, and the measurement data of the phase of the radio signal, which is a millimeter wave transmitted from the antenna element, is acquired.

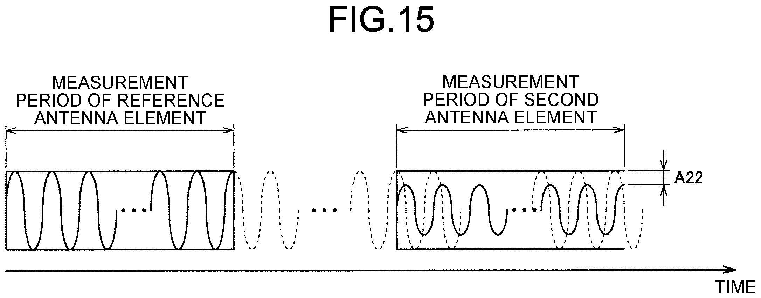

In addition, FIG. 15 is an explanatory diagram for describing a method of measuring amplitude of a radio signal which is a millimeter wave in the information processing system according to the present embodiment. As illustrated in FIG. 15, in the first measurement period, a radio signal which is a millimeter wave is transmitted from the reference antenna element, and the radio signal is taken into the vector signal analyzer 291.

Next, in the second measurement period, a radio signal which is a millimeter wave is transmitted from the second antenna element, and the radio signal is taken into the vector signal analyzer 291. In this case, the vector signal analyzer 291 compares the radio signal which is the millimeter wave taken into the second antenna element with the radio signal which is the millimeter wave taken into the reference antenna element, thereby calculating an amplitude (power) difference A22. That is, the amplitude difference A22 corresponds to the relative amplitude difference between the radio signals which are millimeter waves transmitted from each of the reference antenna element and the second antenna element. Then, the calculated amplitude difference A22 is held as the measurement data of the phase for the second antenna element.

As described above, each antenna element included in the antenna device is sequentially validated, and the measurement data of the amplitude of the radio signal, which is a millimeter wave transmitted from the antenna element, is acquired.

(Supplement)

The information processing system according to the present embodiment has a configuration as illustrated in FIG. 11, and therefore, no longer needs to apply a configuration in which a hole is formed in the housing of the terminal device, a cable is connected to the BB modem provided in the terminal device via the hole, and various signals related to radio signal transmission are input from VNA via the cable. Therefore, according to the information processing system according to the present embodiment, it is possible to configure a measurement system without requiring complicated and delicate operation. Further, as described above, the terminal device 200 autonomously compensates for the shift of the frequency by channel estimation and frequency tracking based on the reference signal transmitted from the LTE link antenna 289. Therefore, even in a situation where the frequency shift may occur due to the influence of the heat dissipation or the like due to a long measurement time, the terminal device 200 itself autonomously compensates for the frequency shift.

In addition, since the terminal device holds the above-described LUT, the FR2 system has the ability (BC Capability) to align the beams spatially with each other on the base station side and the UE (5G terminal) side as the operation of the FR2 system, so it becomes possible to realize beamforming in a more preferable manner.

On the other hand, as a method for measuring and evaluating the conformance of FR2 in 3GPP, it has been agreed in 3GPP RAN5 that the battery-powered DUT is tested only with the nominal voltage without a power cable. More specifically, the extreme voltage is not applied, and the measurement is performed using a single battery without applying the "dummy battery" or "charging with a USB cable". The reason for this is that the influence of the connection cable due to the application of "dummy battery" or "charging with USB cable" may affect the measurement result of FR2.

In view of such a situation, in the information processing system according to the present embodiment, it is possible to selectively switch the method of controlling the measuring instrument side (for example, vector signal analyzer 291) and the terminal device (5G terminal) side according to the situation when carrying out the measurement related to the generation of the LUT. An example of a method of controlling the measuring instrument side and the UE (5G terminal) side will be described below as (Example 1) and (Example 2).

• First Embodiment

When generating the LUT for each antenna device provided in the terminal device (5G terminal), both the measuring instrument and the terminal device may be controlled by using a dedicated test SIM.

• Second Embodiment

When generating the LUT for each antenna device provided in the terminal device (5G terminal), the control software is operated on both the measuring instrument and the terminal device. In this case, on the measuring instrument side, the above software may be controlled from an external device (for example, a PC or the like) via IEEE 488 or Ethernet (registered trademark). Further, the terminal device side may be controlled from the above-described external device via a cable connection using the USB.

For example, when there is a concern that the influence of the connection cable due to the application of "dummy battery" or "charging with USB cable" will affect the measurement result of FR2, as agreed in 3GPP RAN5, for example, the application of (first embodiment) is recommended.

On the other hand, when the measurement system can be set so that the influence of the USB cable on the terminal device (5G terminal) side does not affect the measurement result of FR2, by applying (second embodiment), it is possible to supply power to the terminal device via the USB cable. That is, in this case, even when the measurement time is long, it is possible to prevent the occurrence of a situation in which the power for operating the terminal device is exhausted.

Of course, the above is just an example, and the method is not particularly limited as long as the measuring instrument side and the terminal device (5G terminal) side can be controlled in synchronization with time.

(Action Effect)

As described above, according to an information processing system according to the embodiment of the present disclosure, even in a situation where the frequency shift may occur due to the influence of the heat dissipation or the like due to the long measurement time, the terminal device 200 itself autonomously compensates for the deviation of the frequency. Due to these characteristics, it is possible to prevent the occurrence of the measurement errors due to the environmental factors such as the heat dissipation when acquiring the measurement data related to the generation of the LUT.

In addition, according to the information processing system according to the present embodiment, a configuration in which a hole is formed in the housing of the terminal device, a cable is connected to the BB modem provided in the terminal device via the hole, and various signals related to radio signal transmission are input from VNA via the cable is no longer required. Due to such characteristics, it is possible to configure the measurement system without requiring complicated and delicate operation.

<<6. Hardware Configuration>>

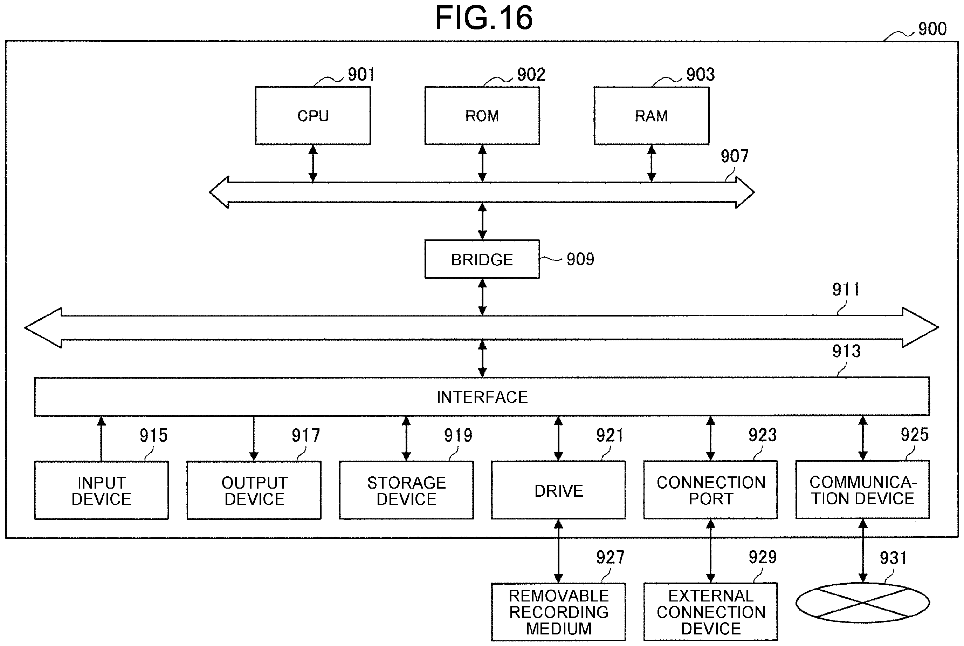

Subsequently, details of an example of the hardware configuration of the information processing device constituting the system according to an embodiment of the present disclosure, such as the base station 100, the terminal device 200, and the control device 295 described above, will be described with reference to FIG. 16. FIG. 16 is a functional block diagram illustrating a configuration example of a hardware configuration of an information processing device constituting the system according to an present embodiment.

An information processing device 900 constituting the system according to the present embodiment mainly includes a CPU 901, a ROM 902, and a RAM 903. Further, the information processing device 900 further includes a host bus 907, a bridge 909, an external bus 911, an interface 913, an input device 915, an output device 917, a storage device 919, a drive 921, a connection port 923, and a communication device 925.

The CPU 901 functions as an arithmetic processing device and a control device, and controls all or a part of the operation in the information processing device 900 according to various programs recorded in the ROM 902, the RAM 903, the storage device 919, or the removable recording medium 927. The ROM 902 stores programs, operation parameters, or the like used by the CPU 901. The RAM 903 primary stores the program used by the CPU 901, parameters that change as appropriate in the execution of the program, and the like. These are connected to each other by a host bus 907 including an internal bus such as a CPU bus. For example, the communication control unit 150 of the base station 100 illustrated in FIG. 2 or the communication control unit 240 of the terminal device 200 illustrated in FIG. 3 may be configured by the CPU 901. In addition, various functions of control device 295 can be realized by the operation of CPU 901.

The host bus 907 is connected to an external bus 911 such as a peripheral component interconnect/interface (PCI) bus via the bridge 909. Further, the input device 915, the output device 917, the storage device 919, the drive 921, the connection port 923, and the communication device 925 are connected to the external bus 911 via the interface 913.

As the input device 915, for example, a mouse, a keyboard, a touch panel, a button, a switch, a lever, and the like are an operating means operated by the user. Further, the input device 915 may be, for example, a remote control device (so-called remote controller) using infrared rays or other radio waves, or may be an external connection device 929 such as a mobile phone or PDA that responds to the operation of the information processing device 900. Furthermore, the input device 915 may include, for example, an input control circuit or the like that generates an input signal based on the information input by the user using the above-described operating means and outputs the input signal to the CPU 901. By operating the input device 915, the user of the information processing device 900 can input various data to the information processing device 900 and instruct the processing operation.

The output device 917 is constituted by a device capable of visually or aurally notifying the user of the acquired information. Such devices include display devices such as a CRT display device, a liquid crystal display device, a plasma display device, an EL display device, and a lamp or audio output devices such as a speaker and a headphone, a printer device, or the like. The output device 917 outputs the results obtained by various processes performed by the information processing device 900, for example. Specifically, the display device displays the results obtained by various processes performed by the information processing device 900 as text or an image. On the other hand, the audio output device converts and outputs an audio signal composed of reproduced audio data, acoustic data, etc. into an analog signal.

The storage device 919 is a device for storing data configured as an example of a storage unit of the information processing device 900. The storage device 919 is constituted by a magnetic storage device such as a hard disk drive (HDD), a semiconductor storage device, an optical storage device, a magneto-optical storage device, or the like. The storage device 919 stores programs executed by the CPU 901, various data, and the like. For example, the storage unit 140 of the base station 100 illustrated in FIG. 2 or the storage unit 230 of the terminal device 200 illustrated in FIG. 3 is constituted by any of the storage device 919, the ROM 902, and the RAM 903, or a combination of two or more of the storage devices 919, the ROM 902, and the RAM 903.

The drive 921 is a reader/writer for a storage medium, and is built in or externally attached to the information processing device 900. The drive 921 reads information recorded in a removable recording medium 927 such as a mounted magnetic disk, an optical disk, a magneto-optical disk, or a semiconductor memory, and outputs the read information to the RAM 903. The drive 921 can also write a record to the removable recording medium 927 such as the mounted magnetic disk, optical disk, magneto-optical disk, or semiconductor memory. The removable recording medium 927 is, for example, DVD media, HD DVD media, or Blu-ray (registered trademark), and the like. Further, the removable recording medium 927 may be a compact flash (registered trademark) (CF: CompactFlash), a flash memory, a secure digital (SD) memory card, or the like. In addition, the removable recording medium 927 may be, for example, an integrated circuit (IC) card on which a non-contact IC chip is mounted, an electronic device, or the like.

The connection port 923 is a port for directly connecting to the information processing device 900. As an example of the connection port 923, there are a universal serial bus (USB) port, an IEEE1394 port, a small computer system interface (SCSI) port, and the like. As another example of the connection port 923, there are an RS-232C port, an optical audio terminal, a high-definition multimedia interface (HDMI(registered trademark)) port, and the like. By connecting the external connection device 929 to the connection port 923, the information processing device 900 acquires various data directly from the external connection device 929 or provides various data to the external connection device 929.

The communication device 925 is, for example, a communication interface formed of a communication device or the like for connecting to the communication network (network) 931. The communication device 925 is, for example, a communication card or the like for wired or wireless local area network (LAN), Bluetooth (registered trademark), or wireless USB (WUSB). In addition, the communication device 925 may be a router for optical communication, a router for asymmetric digital subscriber line (ADSL), a modem for various kinds of communication, or the like. The communication device 925 can transmit and receive signals and the like to and from, for example, among the Internet and other communication equipment according to a predetermined protocol such as TCP/IP. Further, the communication network 931 connected to the communication device 925 is constituted by a network connected by wire or wireless, and may be, for example, the Internet, a home LAN, infrared communication, radio wave communication, satellite communication, or the like. For example, the wireless communication unit 120 and the network communication unit 130 of the base station 100 illustrated in FIG. 2 or the wireless communication unit 220 of the terminal device 200 illustrated in FIG. 3 may be constituted by the communication device 925.

Hereinabove, an example of the hardware configuration capable of implementing the functions of the information processing device 900 constituting the system according to the present embodiment has been shown. Each of the above components may be implemented by using a general-purpose member, or may be implemented by hardware specialized for the functions of each component. Therefore, it is possible to appropriately change the hardware configuration to be used according to the technical level at the time of implementing the present embodiment. Although not illustrated in FIG. 16, various configurations corresponding to the information processing device 900 constituting the system are naturally provided.

It is possible to create a computer program for realizing each function of the information processing device 900 constituting the system according to the present embodiment as described above and implement the computer program on a personal computer or the like. In addition, it is also possible to provide a computer-readable recording medium in which such a computer program is stored. The recording medium is, for example, a magnetic disk, an optical disk, a magneto-optical disk, a flash memory, or the like. Further, the above computer program may be distributed, for example, via a network without using the recording medium. Further, the number of computers for executing the computer program is not particularly limited. For example, a plurality of computers (for example, a plurality of servers, etc.) may execute the computer program in cooperation with each other.

<<7. Application Example>>

Next, an application example of a communication device such as a terminal device 200 according to an embodiment of the present disclosure will be described.

<7.1. Application example 1: Application example to other communication devices>

First, as application example 1, an example in which the technology according to the present disclosure is applied to a device other than a communication terminal such as a smartphone will be described.

In recent years, a technology called Internet of Things (IoT) that connects various things to a network has attracted attention, and it is assumed that devices other than smartphones and tablet terminals can also be used for communication. Therefore, for example, by applying the technology according to the present disclosure to various devices configured to be movable, it is possible to realize communication using millimeter waves in a more preferable manner for the devices as well.

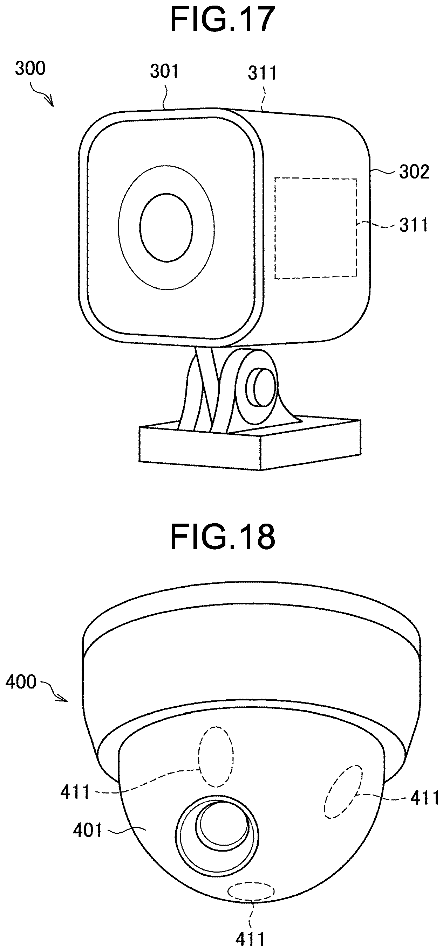

For example, FIG. 17 is an explanatory diagram for describing an application example of the communication device according to the present embodiment, and illustrates an example when the technology according to the present disclosure is applied to a camera device. Specifically, in the example illustrated in FIG. 17, the antenna device according to the embodiment of the present disclosure is held so as to be located in the vicinity of the surfaces 301 and 302 facing different directions from the outer surface of the housing of the camera device 300. For example, reference numeral 311 schematically indicates an antenna device according to an embodiment of the present disclosure. With such a configuration, a camera device 300 illustrated in FIG. 17 can transmit or receive, for example, a radio signal propagating in a direction substantially matching a normal direction of surfaces 301 and 302, respectively. Note that an antenna device 311 may be provided not only on the surfaces 301 and 302 illustrated in FIG. 17 but also on other surfaces.

With the above configuration, based on the above-described technology according to the present disclosure, communication with another device (for example, a base station) using a directional beam is controlled according to a change in the attitude of the camera device 300, so it becomes possible to realize communication using millimeter waves in a more preferable manner.

In addition, the technology according to the present disclosure can also be applied to an unmanned aerial vehicle called a drone. For example, FIG. 18 is an explanatory diagram for describing an application example of the communication device according to the present embodiment, and illustrates an example when the technology according to the present disclosure is applied to a camera device installed at a lower portion of a drone. Specifically, in the case of a drone flying at a high place, it is preferable to be able to transmit or receive radio signals (millimeter waves) arriving from each direction mainly on the lower side. Therefore, for example, in the example illustrated in FIG. 18, the antenna device according to the present disclosure is held so that an outer surface 401 of a housing of a camera device 400 installed at the lower portion of the drone is located in the vicinity of each portion facing different directions. For example, reference numeral 411 schematically indicates an antenna device according to an embodiment of the present disclosure. Further, although not illustrated in FIG. 18, the present disclosure is not limited to the camera device 400, and for example, an antenna device 411 may be provided in each part of the housing of the drone itself. Even in this case, it is particularly preferable that the antenna device 411 is provided on the lower side of the housing.

As illustrated in FIG. 18, when at least a part of the outer surface of the housing of the target device is configured as a curved surface, it is preferable that the antenna device 411 is held in the vicinity of each of the plurality of partial regions, in which normal directions intersect with each other or normal directions are twisted with each other, of each partial region in the curved surface. With such a configuration, the camera device 400 illustrated in FIG. 18 can transmit or receive a radio signal propagating in a direction substantially matching the normal direction of each partial region.

With the above configuration, based on the above-described technology according to the present disclosure, communication with another device (for example, a base station) using a directional beam is controlled according to a change in the attitude of the drone, so it becomes possible to realize communication using millimeter waves in a more preferable manner.

Of course, the examples described with reference to FIGS. 17 and 18 are merely examples, and the application destination of the technique according to the present disclosure is not particularly limited as long as it is a device that performs communication using millimeter waves. For example, there are a wide variety of new business areas to be added in 5G, such as an automobile field, an industrial equipment field, a home security field, a smart meter field, and other IoT fields, and it is possible to apply the technology according to the present disclosure to communication terminals applied in each field. As a more specific example, application destinations of the technology according to the present disclosure include head-mounted wearable devices used for realizing AR or VR, various wearable devices used in telemedicine, and the like. Further, as another example, the technology according to the present disclosure can be applied to a so-called portable game device, a camcorder for a broadcasting station, etc., when wireless communication is possibly configured. Further, in recent years, various so-called autonomous robots such as customer service robots, pet-type robots, and work robots have been proposed, and when the robots have a communication function, the technology according to the present disclosure can also be applied to such robots. Further, the technology according to the present disclosure may be applied not only to the drone described above but also to various moving objects such as automobiles, motorcycles, bicycles and the like.

As an application example 1, an example in which the technology according to the present disclosure is applied to a device other than a communication terminal such as a smartphone has been described with reference to FIGS. 17 and 18.

<7.2. Application example 2: Application example to communication based on other communication standards>

Next, as application example 2, an example in which the technology according to the present disclosure is applied to communications other than communication using millimeter waves in 5G will be described by focusing on, in particular, application to communications based on other communication standards.

Further, in the above, by mainly focusing on 5G wireless communication technology, an example of applying the technology according to the present disclosure to communication using millimeter waves between a base station and a terminal device was described. On the other hand, in the case of communication using a directional beam, the application destination of the technology according to the present disclosure is not necessarily limited to communication between a base station and a terminal device or communication using millimeter waves.

As a specific example, the technique according to the present disclosure can be applied to communications based on the IEEE802.11ad standard that uses the 60 GHz band, communications based on the IEEE802.11ay standard for which standardization work is underway, or the like, among wireless communications based on the Wi-Fi (registered trademark) standard.

In the IEEE802.11ad standard or the IEEE802.11ay standard, beamforming technology is used in the same manner as the above-described 5G wireless communication technology because the influence of free space reduction, absorption by oxygen, and rainfall attenuation are large. As a specific example, the beamforming procedure in the IEEE 802.11ad standard is mainly divided into two stages: sector level sweep (SLS) and beam refinement protocol (BRP).

More specifically, the SLS searches for a communication partner and starts communication. The maximum number of sectors is 64 for one ANT, and 128 for the total of all ANTs. BRP is appropriately implemented after the end of SLS, for example, after the ring is broken, and the like. Such an operation is similar to a mechanism in which BPL is established by wide beam in operation based on IA procedure in millimeter wave communication in 5G, and BPL in narrow beam is established by the operation of beam refinement (BR) in beam management (BM) in a CONNECTED mode.

The IEEE802.11ay standard is currently under development, but similar to "contiguous" "intra-CA" in communication using millimeter waves in 5G, speeding up a data rate by combining channel bonding technology and higher-order modulation is being studied.

From the above characteristics, it is also possible to apply the above-described technology according to the present disclosure to communication based on the IEEE802.11ad standard and the IEEE802.11ay standard.

Of course, the technology according to the present disclosure can be applied to the standards succeeding the various standards described above when communication using the directional beam is assumed. In particular, in wireless communication using a frequency band exceeding millimeter waves, it is presumed that beamforming technology is likely to be applied because it is affected by free space attenuation, absorption by the atmosphere, rainfall attenuation, etc., more than communication using the millimeter wave.

Hereinabove, as application example 2, an example in which the technology according to the present disclosure is applied to communications other than communication using millimeter waves in 5G was described by focusing on, in particular, application to communications based on other communication standards.

<<8. Conclusion>>

As described above, the information processing device according to the embodiment of the present disclosure includes a generation unit that generates control information for controlling the directivity of the radio signal transmitted from the antenna device including a plurality of antenna elements. The generation unit acquires first information according to a measurement result of a phase of a radio signal transmitted from a first antenna element among the plurality of antenna elements, and second information according to a measurement result of a relative deviation between the phase of the radio signal transmitted from the first antenna element and a phase of a radio signal transmitted from a second antenna element different from the first antenna element. Then, the generation unit generates the control information based on the first information and the second information. Further, the terminal device according to the embodiment of the present disclosure is a control unit that controls the directivity of an antenna device including a plurality of antenna elements and a radio signal transmitted from the antenna device based on the control information generated in advance.

With the above configuration, it is possible to reduce an influence of errors caused by a hardware configuration of an antenna device in controlling directivity of a radio signal in a more preferable manner.

As described above, the preferred embodiments of the present disclosure have been described in detail with reference to the accompanying drawings, but the technical scope of the present disclosure is not limited to such examples. It will be apparent to those skilled in the art of the present disclosure that various changes or modifications can be conceived within the scope of the technical idea described in the claims, and it is naturally understood that these changes or modifications fall within the technical scope of the present disclosure.

In addition, the effects described in the present specification are merely illustrative or exemplary, and are not limited to those described in the present specification. That is, the technology according to the present disclosure can exhibit other effects apparent to those skilled in the art from the description of the present specification, in addition to or instead of the effects described above.

The following configurations are also within the technical scope of the present disclosure.

(1) An information processing device, comprising:

a generation unit that generates control information for controlling directivity of a radio signal transmitted from an antenna device including a plurality of antenna elements,
wherein the generation unit acquires
first information according to a measurement result of a phase of a radio signal transmitted from a first antenna element among the plurality of antenna elements, and
second information according to a measurement result of a relative deviation between the phase of the radio signal transmitted from the first antenna element and a phase of a radio signal transmitted from a second antenna element different from the first antenna element, and
generates the control information based on the first information and the second information.

(2) The information processing device according to (1), wherein

the first information includes information according to a measurement result of an amplitude of the radio signal transmitted from the first antenna element, and
the second information includes information according to a measurement result of a relative deviation between the amplitude of the radio signal transmitted from the first antenna element and an amplitude of the radio signal transmitted from the second antenna element.

(3) The information processing device according to (1) or (2), wherein the control information is generated based on the first information and the second information acquired for each attitude of the antenna device.

(4) The information processing device according to any one of (1) to (3), wherein the generation unit recognizes a timing at which a terminal device including the antenna device transmits the radio signal to the antenna device based on information notified from a communication device configured to be able to communicate with the terminal device.

(5) An information processing system, comprising:

a terminal device including an antenna device that includes a plurality of antenna elements; and

an information processing device in which the antenna device generates control information for controlling directivity of a radio signal,

wherein the information processing device acquires

first information according to a measurement result of a phase of a radio signal transmitted from a first antenna element among the plurality of antenna elements, and

second information according to a measurement result of a relative deviation between the phase of the radio signal transmitted from the first antenna element and a phase of a radio signal transmitted from a second antenna element different from the first antenna element, and

generates the control information based on the first information and the second information.

(6) The information processing system according to (5), wherein

the first information includes information according to a measurement result of an amplitude of the radio signal transmitted from the first antenna element, and

the second information includes information according to a measurement result of a relative deviation between the amplitude of the radio signal transmitted from the first antenna element and an amplitude of the radio signal transmitted from the second antenna element.

(7) The information processing system according to (5) or (6), further comprising:

a communication device wirelessly communicating with the terminal device using a frequency band different from a frequency band in which the radio signal is transmitted,

wherein the terminal device controls the transmission of the radio signal based on a control signal transmitted from the communication device.

(8) The information processing system according to (7), wherein the terminal device corrects a frequency shift of the radio signal based on the control signal.

(9) The information processing system according to (7) or (8), wherein

the communication device transmits a control signal to the terminal device, and notifies the information processing device of information on the control signal,

the terminal device controls a transmission timing of the radio signal based on the control signal, and

the information processing device recognizes the transmission timing based on the information on the control signal.

(10) The information processing system according to any one of (5) to (9), further comprising:

an attitude control device that controls an attitude of the terminal device,

wherein the control information is generated based on the first information and the second information acquired for each attitude of the antenna device according to the attitude of the terminal device.

(11) The information processing system according to any one of (5) to (10), wherein

the terminal device includes the plurality of antenna devices, and

the control information is generated based on the first information and the second information acquired for each of the plurality of antenna devices.

(12) A terminal device, comprising:

an antenna device including a plurality of antenna elements, and

a control unit that controls directivity of a radio signal transmitted from the antenna device based on control information generated in advance,

wherein the control information is generated based on

first information according to a measurement result of a phase of a radio signal transmitted from a first antenna element among the plurality of antenna elements, and

second information according to a measurement result of a relative deviation between the phase of the radio signal transmitted from the first antenna element and a phase of a radio signal transmitted from a second antenna element different from the first antenna element.

(13) The terminal device according to (12), wherein

the first information includes information according to a measurement result of an amplitude of the radio signal transmitted from the first antenna element, and
the second information includes information according to a measurement result of a relative deviation between the amplitude of the radio signal transmitted from the first antenna element and an amplitude of the radio signal transmitted from the second antenna element.

(14) An information processing method, by a computer, comprising:

acquiring
first information according to a measurement result of a phase of a radio signal transmitted from a first antenna element among a plurality of antenna elements included in an antenna device, and
second information according to a measurement result of a relative deviation between the phase of the radio signal transmitted from the first antenna element and a phase of a radio signal transmitted from a second antenna element different from the first antenna element; and
generating control information for controlling directivity of a radio signal transmitted from the antenna device based on the first information and the second information.

Reference Signs List

| | |
|---|---|
| 10 | INFORMATION PROCESSING SYSTEM |
| 200 | TERMINAL DEVICE |
| 210 | ANTENNA UNIT |
| 220 | WIRELESS COMMUNICATION UNIT |
| 230 | STORAGE UNIT |
| 230 | DETECTION UNIT |
| 240 | COMMUNICATION CONTROL UNIT |
| 250 | ANTENNA DEVICE |
| 251 | MIXER |
| 253 | RF DISTRIBUTOR (SYNTHESIZER) |
| 255 | ANTENNA UNIT |
| 257 | PHASER |
| 259a, 259b | SWITCH |
| 261 | AMPLIFIER |
| 263 | AMPLIFIER |
| 265 | ANTENNA ELEMENT |
| 281 | ATTITUDE CONTROL DEVICE |
| 283 | POSITION CONTROLLER |
| 285 | REFLECTOR |
| 287 | FEED ANTENNA |
| 289 | LTE LINK ANTENNA |
| 291 | VECTOR SIGNAL ANALYZER |
| 293 | LTE SYSTEM SIMULATOR |
| 295 | CONTROL DEVICE |

**Claims**

1. An information processing device, comprising:

a generation unit that generates control information for controlling directivity of a radio signal transmitted from an antenna device including a plurality of antenna elements,
wherein the generation unit acquires
first information according to a measurement result of a phase of a radio signal transmitted from a first antenna element among the plurality of antenna elements, and

second information according to a measurement result of a relative deviation between the phase of the radio signal transmitted from the first antenna element and a phase of a radio signal transmitted from a second antenna element different from the first antenna element, and
generates the control information based on the first information and the second information.

2. The information processing device according to claim 1, wherein

the first information includes information according to a measurement result of an amplitude of the radio signal transmitted from the first antenna element, and
the second information includes information according to a measurement result of a relative deviation between the amplitude of the radio signal transmitted from the first antenna element and an amplitude of the radio signal transmitted from the second antenna element.

3. The information processing device according to claim 1, wherein the control information is generated based on the first information and the second information acquired for each attitude of the antenna device.

4. The information processing device according to claim 1, wherein the generation unit recognizes a timing at which a terminal device including the antenna device transmits the radio signal to the antenna device based on information notified from a communication device configured to be able to communicate with the terminal device.

5. An information processing system, comprising:

a terminal device including an antenna device that includes a plurality of antenna elements; and
an information processing device in which the antenna device generates control information for controlling directivity of a radio signal,
wherein the information processing device acquires
first information according to a measurement result of a phase of a radio signal transmitted from a first antenna element among the plurality of antenna elements, and
second information according to a measurement result of a relative deviation between the phase of the radio signal transmitted from the first antenna element and a phase of a radio signal transmitted from a second antenna element different from the first antenna element, and
generates the control information based on the first information and the second information.

6. The information processing system according to claim 5, wherein

the first information includes information according to a measurement result of an amplitude of the radio signal transmitted from the first antenna element, and
the second information includes information according to a measurement result of a relative deviation between the amplitude of the radio signal transmitted from the first antenna element and an amplitude of the radio signal transmitted from the second antenna element.

7. The information processing system according to claim 5, further comprising:

a communication device wirelessly communicating with the terminal device using a frequency band different from a frequency band in which the radio signal is transmitted,
wherein the terminal device controls the transmission of the radio signal based on a control signal transmitted from the communication device.

8. The information processing system according to claim 7, wherein the terminal device corrects a frequency shift of the radio signal based on the control signal.

9. The information processing system according to claim 7, wherein

the communication device transmits a control signal to the terminal device, and notifies the information processing device of information on the control signal,
the terminal device controls a transmission timing of the radio signal based on the control signal, and
the information processing device recognizes the transmission timing based on the information on the control signal.

**10.** The information processing system according to claim 5, further comprising:

an attitude control device that controls an attitude of the terminal device,
wherein the control information is generated based on the first information and the second information acquired for each attitude of the antenna device according to the attitude of the terminal device.

**11.** The information processing system according to claim 5, wherein

the terminal device includes the plurality of antenna devices, and
the control information is generated based on the first information and the second information acquired for each of the plurality of antenna devices.

**12.** A terminal device, comprising:

an antenna device including a plurality of antenna elements, and
a control unit that controls directivity of a radio signal transmitted from the antenna device based on control information generated in advance,
wherein the control information is generated based on
first information according to a measurement result of a phase of a radio signal transmitted from a first antenna element among the plurality of antenna elements, and
second information according to a measurement result of a relative deviation between the phase of the radio signal transmitted from the first antenna element and a phase of a radio signal transmitted from a second antenna element different from the first antenna element.

**13.** The terminal device according to claim 12, wherein

the first information includes information according to a measurement result of an amplitude of the radio signal transmitted from the first antenna element, and
the second information includes information according to a measurement result of a relative deviation between the amplitude of the radio signal transmitted from the first antenna element and an amplitude of the radio signal transmitted from the second antenna element.

**14.** An information processing method, by a computer, comprising:

acquiring
first information according to a measurement result of a phase of a radio signal transmitted from a first antenna element among a plurality of antenna elements included in an antenna device, and
second information according to a measurement result of a relative deviation between the phase of the radio signal transmitted from the first antenna element and a phase of a radio signal transmitted from a second antenna element different from the first antenna element; and
generating control information for controlling directivity of a radio signal transmitted from the antenna device based on the first information and the second information.

FIG.1

# FIG.2

110

100

120
WIRELESS
COMMUNICA-
TION UNIT

150
COMMUNICA-
TION CONTROL
UNIT

130
NETWORK
COMMUNICA-
TION UNIT

140
STORAGE UNIT

# FIG.3

210

200

220
WIRELESS
COMMUNICA-
TION UNIT

240
COMMUNICA-
TION CONTROL
UNIT

230
STORAGE UNIT

# FIG.4

**FIG.5**

# FIG.6

EP 3 952 122 A1

# FIG.7 <span>P1 PROCEDURE : BEAM SELECTION AND BEAM RESELECTION</span>

TRP — B101 — B111 — UE

P2 PROCEDURE : Tx BEAM REFINEMENT

TRP — B103 — B111 — UE

P3 PROCEDURE : Rx BEAM REFINEMENT

TRP — B103 — B113 — UE

EP 3 952 122 A1

# FIG.8

# FIG.9

# FIG.10

FIG.11

EP 3 952 122 A1

# FIG.12

271a    271b    271c    271d

250

265a    265b    265c    265d

# FIG.13

| Patch2 | V_Mag | V_Ph | H_Mag | H_Ph | Patch1 | V_Mag | V_Ph | H_Mag | H_Ph |
|---|---|---|---|---|---|---|---|---|---|
| — | Ref00 | Ref00 | Ref00 | Ref00 | — | delta1.5 | delta−101.5 | delta3.1 | delta−121.5 |
| — | Ref03 | Ref03 | Ref03 | Ref03 | — | delta1.8 | delta−110.5 | delta3.8 | delta−111.4 |
| — | Ref06 | Ref06 | Ref06 | Ref06 | — | delta2.2 | delta−118.5 | delta5.2 | delta−99.9 |

| Patch3 | V_Mag | V_Ph | H_Mag | H_Ph | Patch4 | V_Mag | V_Ph | H_Mag | H_Ph | elevation | azimuth |
|---|---|---|---|---|---|---|---|---|---|---|---|
| — | delta2.2 | delta5.5 | delta1.2 | delta110.5 | — | delta1.2 | delta25.5 | delta1.5 | delta55.5 | 0 | 0 |
| — | delta2.8 | delta11.8 | delta1.4 | delta101.9 | — | delta1.5 | delta18.8 | delta1.9 | delta52.1 | 0 | 3 |
| — | delta3.1 | delta18.9 | delta2.2 | delta88.8 | — | delta1.9 | delta16.7 | delta2.8 | delta48.8 | 0 | 6 |

# FIG.14

MEASUREMENT
PERIOD OF REFERENCE
ANTENNA ELEMENT

MEASUREMENT
PERIOD OF SECOND
ANTENNA ELEMENT

MEASUREMENT
PERIOD OF THIRD
ANTENNA ELEMENT

TIME

T12

T13

EP 3 952 122 A1

# FIG.15

MEASUREMENT PERIOD OF REFERENCE ANTENNA ELEMENT

MEASUREMENT PERIOD OF SECOND ANTENNA ELEMENT

A22

TIME

EP 3 952 122 A1

# FIG.16

EP 3 952 122 A1

# FIG.17

# FIG.18

**INTERNATIONAL SEARCH REPORT**

| International application No. |
| --- |
| PCT/JP2019/016506 |

**A. CLASSIFICATION OF SUBJECT MATTER**
Int. Cl. H04B7/0413(2017.01)i, G01R29/10(2006.01)i, H04B7/06(2006.01)i

According to International Patent Classification (IPC) or to both national classification and IPC

**B. FIELDS SEARCHED**

Minimum documentation searched (classification system followed by classification symbols)
Int. Cl. H04B7/0413, G01R29/10, H04B7/06

Documentation searched other than minimum documentation to the extent that such documents are included in the fields searched
Published examined utility model applications of Japan       1922-1996
Published unexamined utility model applications of Japan     1971-2019
Registered utility model specifications of Japan             1996-2019
Published registered utility model applications of Japan     1994-2019

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2019-57850 A (NEC SPACE TECHNILOGIES LTD.) 11 April 2019, paragraphs [0001]-[0003], [0012], [0013], fig. 1 (Family: none) | 1, 2, 14<br>3, 5-6, 10-13<br>4, 7-9 |
| Y | WO 2008/139832 A1 (MURATA MFG. CO., LTD.) 20 November 2008, paragraphs [0023]-[0032], fig. 1 & JP 4438905 B2 & US 2010/0045543 A1, paragraphs [0031]-[0041], fig. 1 & KR 10-2009-0130397 A & CN 101675345 A | 3, 5-6, 10-13 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13.06.2019 | Date of mailing of the international search report<br>02.07.2019 |
| --- | --- |
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**INTERNATIONAL SEARCH REPORT**

| | International application No. |
|---|---|
| | PCT/JP2019/016506 |

C (Continuation).   DOCUMENTS CONSIDERED TO BE RELEVANT

| Category* | Citation of document, with indication, where appropriate, of the relevant passages | Relevant to claim No. |
|---|---|---|
| Y | Ericsson, MVG Industries, Kathrein, TP to TR 37.842: On Test Methods[online], 3GPP TSG-RAN WG4#78bis R4-162966, 26 April 2016, [retrieved on: 07 August 2016], Internet <URL: http://www.3gpp.org/ftp/tsg_ran/WG4_Radio/TSGR4_78 Bis/Docs/R4-162966.zip> | 3, 5-6, 10-13 |
| A | JP 2012-124749 A (DENSO CORP.) 28 June 2012 & US 2012/0146841 A1 & CN 102544734 A | 1-14 |
| A | JP 2017-187406 A (ANRITSU CORP.) 12 October 2017 (Family: none) | 1-14 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SATOSHI SUYAMA et al.** 5G Multi-Antenna Technology. *NTT DOCOMO Technical Journal,* 2016, vol. 23 (4), 30-39